# EUROPEAN PATENT APPLICATION

(11) **EP 4 503 094 A1**
(43) Date of publication of application: **05.02.2025**
(21) Application number: 23774650.8
(22) Date of filing: 13.03.2023
(51) Int. Cl.: H01L 21/304, H01L 21/306

(54) **CIRCULATION DEVICE AND CIRCULATION DEVICE CONTROL METHOD**

(30) Priority: 24.03.2022 JP 2022048309
(71) Applicant: SCREEN Holdings Co., Ltd., Kyoto-shi, Kyoto 602-8585 (JP)
(72) Inventor: KAWAGUCHI, Tatsuhiko, Kyoto-shi, Kyoto 602-8585 (JP)
(74) Representative: Kilian Kilian & Partner mbB
(86) International application number: PCT/JP2023/009647
(87) International publication number: WO 2023/182053

(57) **Abstract**

A temperature and/or a flow velocity of a treatment liquid reach desired values earlier. A circulation apparatus includes: a first pipe which is used for supplying a liquid and into which the liquid flows from a storage tank storing the liquid; a heater disposed in the first pipe which heats the liquid; a pump disposed in the first pipe which expels the liquid; a first valve openable and closeable and connected in the first pipe to the pump through the heater; a second pipe from which the liquid flows into the storage tank and which is connected to the first pipe between the heater and the first valve; and a third pipe which is used for collecting the liquid and from which the liquid flows into the storage tank. While the heater heats the liquid, the first valve is closed during a first period; the first valve is opened, and a pressure loss value of the second pipe is increased during a second period after the end of the first period; and the first valve is opened, and the pressure loss value of the second pipe is reduced during a third period after the end of the second period.

## Description

### TECHNICAL FIELD

The present disclosure relates to a circulation apparatus and a method of controlling the same.

### BACKGROUND ART

In processes of manufacturing semiconductor devices, surfaces of substrates such as semiconductor wafers are subjected to treatments using chemical solutions. Examples of the treatments include a cleaning treatment. Examples of the chemical solutions (including rinse liquids and organic solvents will be referred to as "treatment liquids") include an acid liquid.

For example, single-wafer substrate treatment equipment that treats substrates one by one rotates the substrate while holding the substrate approximately horizontal and supplies a treatment liquid to the surface of the rotating substrate. The aforementioned treatment is applied in a treatment container generally referred to as a chamber.

The treatment liquid is collected and recycled after being supplied to the substrate. Specifically, the treatment liquid is supplied to the chamber, and the treatment liquid after being subjected to the treatment is collected. Here, a circulation apparatus disposed outside the chamber supplies and collects the treatment liquid.

When a plurality of chambers is prepared, these chambers are stored in respective treatment units. The treatment units are stacked in an approximately vertical direction, and are included in a structure generally referred to as a tower. A plurality of towers may be prepared.

The circulation apparatus supplies and collects the treatment liquid to and from each of the towers. Then, the circulation apparatus supplies and collects the treatment liquid to and from the plurality of chambers for each of the towers.

The circulation apparatus performs not only circulation processes of supplying and collecting the treatment liquid to and from the towers (hereinafter provisionally referred to as "external circulation") but also a circulation process of circulating the treatment liquid inside the circulation apparatus without through the towers (hereinafter provisionally referred to as "internal circulation").

For example, Patent Document 1 below describes the external circulation and the internal circulation on each of the towers. For example, Patent Document 2 below describes use of sulfuric acid as a treatment liquid.

### PRIOR ART DOCUMENT

### PATENT DOCUMENT

Patent Document 1: Japanese Patent Application Laid-Open No. 2021-052038
Patent Document 2: Japanese Patent Application Laid-Open No. 2020-088208

### SUMMARY

### PROBLEM TO BE SOLVED BY THE INVENTION

Before the treatment liquid is supplied to the towers through the external circulation, increasing the temperature of the treatment liquid to a desired temperature and causing the treatment liquid to flow at a desired flow velocity through the internal circulation contribute to treating the substrates using the treatment liquid.

A pump circulates the treatment liquid not only in the external circulation but also in the internal circulation. For example, the pump is a rotary pump. Rotation of the pump at a predetermined rotation speed at which the aforementioned circulation is appropriately executed allows the internal circulation.

The internal circulation is also performed even during the external circulation. Variations given by the flow rate of the treatment liquid flowing through the towers to the pressure of the treatment liquid in the circulation apparatus are mitigated by this internal circulation.

After the temperature of the treatment liquid is increased to the desired temperature only through the internal circulation without the external circulation, once the external circulation is started, the external circulation cannot be smoothly performed in some cases. The reason is inferred as below. While the external circulation is terminated, the temperature of the treatment liquid remaining in the towers is low. Generally, the viscosity of a liquid is higher as the temperature of the liquid is lower. Particularly, sulfuric acid exhibits significant viscosity displacement, depending on the temperature. For example, although 98% sulfuric acid exhibits a high viscosity of 23.8 × 10⁻³ Pa·s at a liquid temperature of 25°C, it exhibits a significantly low viscosity of 4.1 × 10⁻³ Pa·s at a liquid temperature of 100°C. When the treatment liquid, viscosity of which highly changes depending on a temperature, such as sulfuric acid, is circulated, once the external circulation is started, the treatment liquid resists flowing through the towers, and the internal circulation is preferentially performed.

The amount and the temperature of the treatment liquid remaining in the towers differ according to circumstances. The treatment liquid remaining in the towers is preferably replaced with a treatment liquid to be supplied from the circulation apparatus so that the temperature and the flow velocity of the treatment liquid to be supplied to the towers in the external circulation have desired values. The time when the replacement is completed (hereinafter a "replacement completion time") differs according to circumstances. The treatment liquid to be supplied to the towers preferably has a desired temperature and a desired flow velocity, until the treatment using a chemical solution is applied.

The present invention has been conceived in view of the problem, and the object is to provide a technology that allows the temperature and/or the flow velocity of a treatment liquid to reach desired values earlier.

### MEANS TO SOLVE THE PROBLEM

A first aspect of a circulation apparatus according to the present disclosure is to supply and collect a liquid to and from an external path. The circulation apparatus includes: a storage tank in which the liquid is an object to be stored; a first pipe including a first inflow end into which the liquid flows from the storage tank, the first pipe being used for supplying the liquid; a heater in which the liquid is an object is to be heated, the heater being disposed in the first pipe; a pump in which the liquid is an object is to be expelled, the pump being disposed in the first pipe and including an inlet connected to the first inflow end and an outlet connected to the heater; a first valve connected in the first pipe to the outlet through the heater, the first valve being openable and closeable; a second pipe including a second inflow end connected to the first pipe between the heater and the first valve, and a second outflow end from which the liquid flows into the storage tank, the second pipe having a pressure loss value being variable; a third pipe including a third outflow end from which the liquid flows into the storage tank, the third pipe being used for collecting the liquid; and a controller controlling opening and closing of the first valve, and controlling the pressure loss value.

While the heater heats the liquid: the controller closes the first valve during a first period; the controller opens the first valve, and increases the pressure loss value during a second period after end of the first period; and the controller opens the first valve, and reduces the pressure loss value during a third period after end of the second period.

A second aspect of the circulation apparatus according to the present disclosure is the first aspect, and further includes a second valve that is disposed in the second pipe and can regulate a flow rate. The controller controls the second valve to control the pressure loss value.

A third aspect of the circulation apparatus according to the present disclosure is the second aspect, wherein the second valve is an on-off valve.

A fourth aspect of the circulation apparatus according to the present disclosure is the second aspect, wherein the second valve is a relief valve.

A fifth aspect of the circulation apparatus according to the present disclosure is any one of the first to fourth aspects, wherein the controller ends the second period and starts the third period when a load of the pump transitions from a state larger than a predetermined value to a state smaller than the predetermined value.

A sixth aspect of the circulation apparatus according to the present disclosure is any one of the first to fourth aspects, wherein the controller ends the second period and starts the third period when a temperature of the liquid flowing through the third pipe transitions from a temperature lower than a predetermined value to a temperature higher than the predetermined value.

A seventh aspect of the circulation apparatus according to the present disclosure is any one of the first to sixth aspects, and further includes a fourth pipe including a fourth inflow end connected to the first valve on an opposite side of the heater, the fourth pipe being used for supplying the liquid. The second period includes a fourth period and a fifth period. The controller causes the liquid to be supplied from the first pipe and causes the liquid not to be supplied from the fourth pipe during the fourth period, and the controller causes the liquid to be supplied from the fourth pipe and causes the liquid not to be supplied from the first pipe, during the fifth period.

A first aspect of a method of controlling a circulation apparatus according to the present disclosure is a method of controlling a circulation apparatus that supplies and collects a liquid to and from an external path. The circulation apparatus includes: a storage tank in which the liquid is an object to be stored; a first pipe including a first inflow end into which the liquid flows from the storage tank, the first pipe being used for supplying the liquid; a heater in which the liquid is an object is to be heated, the heater being disposed in the first pipe; a pump in which the liquid is an object is to be expelled, the pump being disposed in the first pipe and including an inlet connected to the first inflow end and an outlet connected to the heater; a first valve connected in the first pipe to the outlet through the heater, the first valve being openable and closeable; a second pipe including a second inflow end connected to the first pipe between the heater and the first valve, and a second outflow end from which the liquid flows into the storage tank, the second pipe having a pressure loss value being variable; and a third pipe including a third outflow end from which the liquid flows into the storage tank, the third pipe being used for collecting the liquid.

The method while the heater heats the liquid includes: a first process of closing the first valve during a first period; a second process of opening the first valve, and increasing the pressure loss value during a second period after end of the first period; and a third process of opening the first valve, and reducing the pressure loss value during a third period after end of the second period.

A second aspect of the method of controlling the circulation apparatus according to the present disclosure is the first aspect, wherein the circulation apparatus further includes a second valve that is disposed in the second pipe and can regulate a flow rate, the method includes controlling the pressure loss value using the second valve.

A third aspect of the method of controlling the circulation apparatus according to the present disclosure is the second aspect, wherein the second valve is an on-off valve.

A fourth aspect of the method of controlling the circulation apparatus according to the present disclosure is the second aspect, wherein the second valve is a relief valve.

A fifth aspect of the method of controlling the circulation apparatus according to the present disclosure is any one of the first to fourth aspects, and includes ending the second period and starting the third period when a load of the pump transitions from a state larger than a predetermined value to a state smaller than the predetermined value.

A sixth aspect of the method of controlling the circulation apparatus according to the present disclosure is any one of the first to fourth aspects, and includes ending the second period and starting the third period when a temperature of the liquid flowing through the third pipe transitions from a temperature lower than a predetermined value to a temperature higher than the predetermined value.

A seventh aspect of the method of controlling the circulation apparatus according to the present disclosure is any one of the first to sixth aspects, wherein the circulation apparatus further includes a fourth pipe including a fourth inflow end connected to the first valve on an opposite side of the heater, the fourth pipe being used for supplying the liquid. The second process includes: a fourth process of supplying the liquid from the first pipe and not supplying the liquid from the fourth pipe; and a fifth process of supplying the liquid from the fourth pipe and not supplying the liquid from the first pipe.

For example, the liquid is sulfuric acid or a dilution of sulfuric acid.

### EFFECTS OF THE INVENTION

The first aspect of the circulation apparatus and the first aspect of the method of controlling the circulation apparatus according to the present disclosure allow the temperature and/or the flow velocity of a treatment liquid to reach desired values earlier.

The second, third, and fourth aspects of the circulation apparatus according to the present disclosure contribute to implementing the first aspect of the circulation apparatus. The second, third, and fourth aspects of the method of controlling the circulation apparatus according to the present disclosure contribute to implementing the first aspect of the method of controlling the circulation apparatus.

The third aspect of the circulation apparatus is more preferable than the fourth aspect of the circulation apparatus and the third aspect of the method of controlling the circulation apparatus is more preferable than the fourth aspect of the method of controlling the circulation apparatus in significantly increasing the pressure loss value of the second pipe.

The fifth, sixth, and seventh aspects of the circulation apparatus and the fifth, sixth, and seventh aspects of the method of controlling the circulation apparatus according to the present disclosure contribute to ending the second period and starting the third period.

### BRIEF DESCRIPTION OF DRAWINGS

FIG. 1 is a lateral cross-sectional view schematically illustrating substrate treatment equipment.
FIG. 2 is a vertical cross-sectional view schematically illustrating the substrate treatment equipment.
FIG. 3 is a vertical cross-sectional view schematically illustrating a vertical cross-section of the substrate treatment equipment when taken along a line III-III.
FIG. 4 is a side view schematically illustrating an example structure of a left portion of a treatment block viewed in a left direction.
FIG. 5 is a side view schematically illustrating an example structure of a right portion of the treatment block viewed in a right direction.
FIG. 6 is a lateral cross-sectional view schematically illustrating a structure of a treatment unit.
FIG. 7 is a vertical cross-sectional view schematically illustrating the structure of the treatment unit.
FIG. 8 is a block diagram illustrating a functional configuration for controlling operations of each of constituents of the substrate treatment equipment.
FIG. 9 is a block diagram illustrating one example configuration of a controller.
FIG. 10 is a plumbing diagram exemplifying a structure of a circulation apparatus.
FIG. 11 is a block diagram illustrating an outline of functions of a controller.
FIG. 12 is a plumbing diagram exemplifying a structure of the circulation apparatus.
FIG. 13 is a plumbing diagram exemplifying a structure of the circulation apparatus.
FIG. 14 is a timing chart exemplifying execution of external circulation and internal circulation.
FIG. 15 is a plumbing diagram exemplifying a structure of the circulation apparatus according to a first modification.
FIG. 16 is a plumbing diagram exemplifying a structure of the circulation apparatus according to the first modification.
FIG. 17 is a flowchart exemplifying operations of the circulation apparatus.
FIG. 18 is a plumbing diagram exemplifying a structure of the circulation apparatus.
FIG. 19 is a plumbing diagram exemplifying a structure of the circulation apparatus.
FIG. 20 is a flowchart partially exemplifying modified operations of the circulation apparatus.

### DESCRIPTION OF EMBODIMENTS

Embodiments of the present disclosure will be described hereinafter with reference to the attached drawings. The constituent elements described in the embodiments are mere exemplification, and only the exemplification does not intend to limit the scope of the disclosure. The drawings are schematically illustrated. The dimensions and the number of parts in the drawings are illustrated in exaggeration or simplified as appropriate for the sake of easier understanding. The same reference signs are allocated to parts having similar structures and functions in the drawings, and overlapping description will be appropriately omitted.

A right-handed XYZ rectangular coordinate system is employed to illustrate position relationships between the elements in the following description. Specifically, it is assumed that the X-axis and the Y-axis extend in a horizontal direction and the Z-axis extend in a vertical direction (an upward and downward direction). The drawings illustrate a direction in which the arrow point indicates as a positive (plus) direction, and its opposite direction as a negative (minus) direction. Specifically, an upward vertical direction is +Z direction, and a downward vertical direction is -Z direction.

Unless otherwise noted, the expressions indicating relative or absolute positional relationships (e.g., "parallel", "orthogonal", "central") in the DESCRIPTION include those exactly indicating the positional relationships and those where an angle or a distance is relatively changed within tolerance or to the extent that similar functions can be obtained. Unless otherwise noted, the expressions indicating equality between two or more objects (e.g., "same", "equal", and "homogeneous") include those indicating quantitatively exact equality and those in the presence of a difference within tolerance or to the extent that similar functions can be obtained.

Unless otherwise noted, the expressions indicating shapes (e.g., "a rectangular shape" or "a cylindrical shape") include those indicating geometrically exact shapes and those indicating, for example, roughness or a chamfer to the extent that similar advantages can be obtained.

An expression "comprising", "including", "containing", or "having" one constituent element is not an exclusive expression for excluding the presence of the other constituent elements.

Unless otherwise noted, an expression "being coupled" includes a contact state of two elements and a distant state of two elements between which another element is sandwiched.

Unless otherwise noted, "moving" in a direction sometimes includes moving parallel to this direction, and moving in a direction with components identical to those of this direction.

### [1. Structure of substrate treatment equipment]

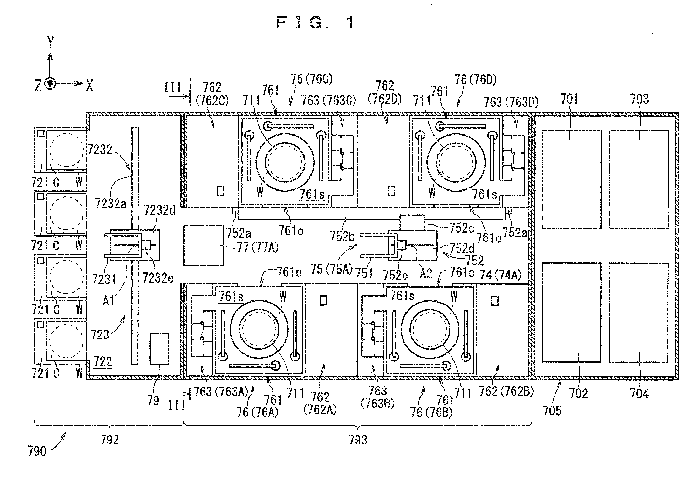

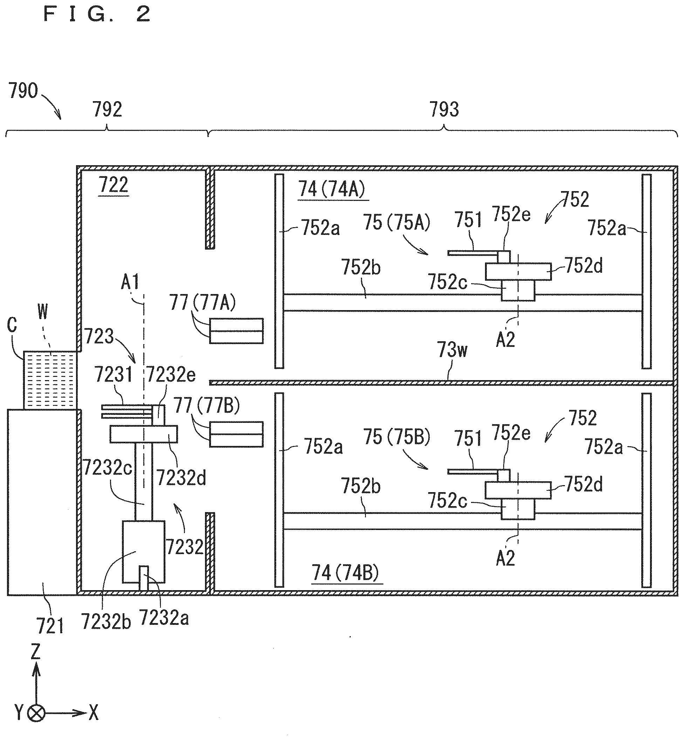

FIG. 1 is a lateral cross-sectional view schematically illustrating substrate treatment equipment 790. FIG. 2 is a vertical cross-sectional view schematically illustrating a vertical cross-section of the substrate treatment equipment 790 along the front and rear direction (±X direction).

The substrate treatment equipment 790 treats a substrate (e.g., a semiconductor wafer) W with a treatment liquid to be supplied and collected to and from a circulation apparatus according to the present disclosure. The circulation apparatus and a method of controlling the same will be described later in detail. The circulation apparatus and the substrate treatment equipment 790 may be collectively understood as a substrate treatment system.

For example, a thin approximately disk-like plate is used as the substrate W. FIG. 1 illustrates, all using broken lines, an outer edge of the substrate W to be stored in each carrier C which will be described later, and an outer edge of the substrate W to be held by each holder 711 which will be described later.

The substrate treatment equipment 790 includes, for example, an indexer 792 and a treatment block 793. The treatment block 793 is coupled to the indexer 792.

The indexer 792 and the treatment block 793 are aligned in a horizontal direction. The indexer 792, for example, supplies the substrates W to the treatment block 793. The treatment block 793, for example, treats the substrates W. The indexer 792, for example, collects the substrates W from the treatment block 793.

In the DESCRIPTION, ±X direction (also referred to as the front and rear direction) is employed for convenience as the horizontal direction in which the indexer 792 and the treatment block 793 are aligned. In the ±X direction (front and rear direction), a direction from the treatment block 793 toward the indexer 792 is employed as -X direction (also referred to as a forward direction or forward), and a direction from the indexer 792 toward the treatment block 793 is to be as +X direction (also referred to as a rear direction or rearward).

A horizontal direction orthogonal to the ±X direction (front and rear direction) is employed as ±Y direction (also referred to as a width direction). In the ±Y direction (width direction), a direction to the right when one faces the -X direction (forward direction) is employed as +Y direction (also referred to as a right direction or right), and a direction to the left when one faces the -X direction (forward direction) is employed as -Y direction (also referred to as a left direction or left).

A direction vertical to the horizontal direction is employed as ±Z direction (also referred to as an upward and downward direction). In the ±Z direction (upward and downward direction), the direction of gravity is employed as -Z direction (also referred to as downward direction or downward), and a direction opposite to the direction of gravity is employed as +Z direction (also referred to as an upward direction or upward). When there is no particular distinction between the front, the rear, the right, and the left, these are all simply referred to as sides.

### [1-1. Structure of indexer]

As illustrated in FIG. 1, the indexer 792 includes a plurality of (e.g., four) carrier placement parts 721, a transport space 722, and at least one (e.g., one) first transport mechanism (also referred to as an indexer mechanism) 723.

The plurality of carrier placement parts 721 are aligned in the width direction (±Y direction). One carrier C is placed on each of the carrier placement parts 721. The carrier C contains a plurality of substrates W. For example, a front opening unified pod (FOUP) is used as the carrier C.

The transport space 722 is located rearward (in the +X direction) of the carrier placement parts 721. The transport space 722 extends in the width direction (±Y direction). The first transport mechanism 723 is located in the transport space 722.

The first transport mechanism 723 is located rearward (in the +X direction) of the carrier placement parts 721. The first transport mechanism 723 transports the substrate W. The first transport mechanism 723 accesses the carrier C placed on each of the carrier placement parts 721.

The first transport mechanism 723 includes a hand 7231 and a hand driving part 7232. The hand 7231 supports the single substrate W in a horizontal orientation. The hand driving part 7232 is coupled to the hand 7231, and moves the hand 7231. Specifically, the hand driving part 7232 moves the hand 7231 in the front and rear direction (±X direction), the width direction (±Y direction), and the upward and downward direction (±Z direction). The hand driving part 7232 includes a plurality of electric motors.

As illustrated in FIGS. 1 and 2, the hand driving part 7232 includes, for example, a rail 7232a, a horizontal mover 7232b, a vertical mover 7232c, a rotator 7232d, and a front and back mover 7232e.

The rail 7232a is fixed to, for example, the bottom of the transport space 722. The rail 7232a extends in the width direction (±Y direction).

The rail 7232a supports the horizontal mover 7232b. The horizontal mover 7232b moves in the width direction (±Y direction) with respect to the rail 7232a.

The horizontal mover 7232b supports the vertical mover 7232c. The vertical mover 7232c moves in the upward and downward direction with respect to the horizontal mover 7232b.

The vertical mover 7232c supports the rotator 7232d. The rotator 7232d rotates relative to the vertical mover 7232c. The rotator 7232d rotates about a rotation axis line A1. The rotation axis line A1 is a virtual line extending in the upward and downward direction.

The front and back mover 7232e moves with respect to the rotator 7232d. The front and back mover 7232e reciprocates in a horizontal direction determined by an orientation of the rotator 7232d. The front and back mover 7232e is connected to the hand 7231.

The hand driving part 7232 implements translating the hand 7231 in the upward and downward direction and in any horizontal direction, and rotationally moving the hand 7231 about the rotation axis line A1.

### [1-2. Structure of treatment block]

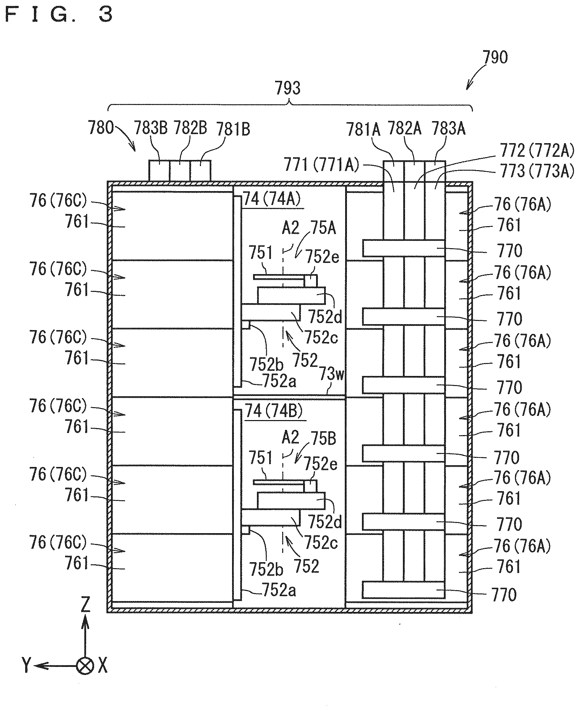

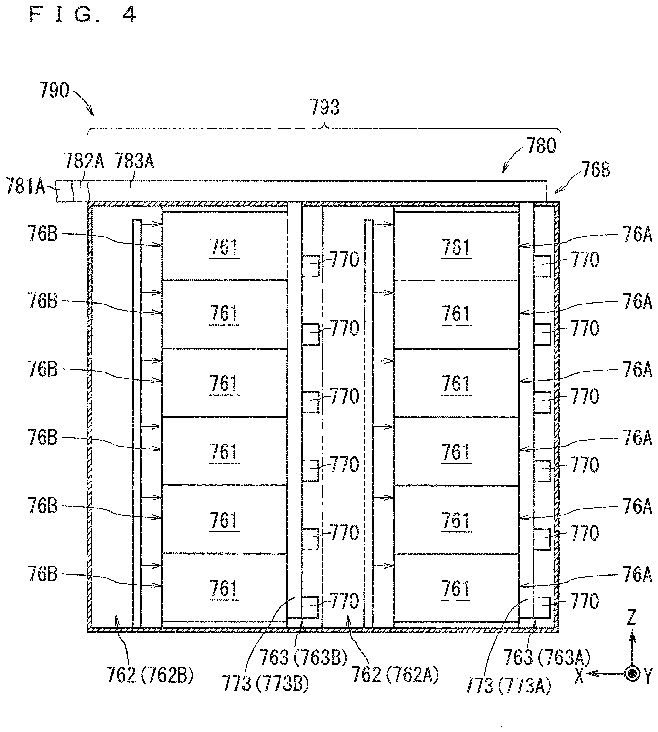

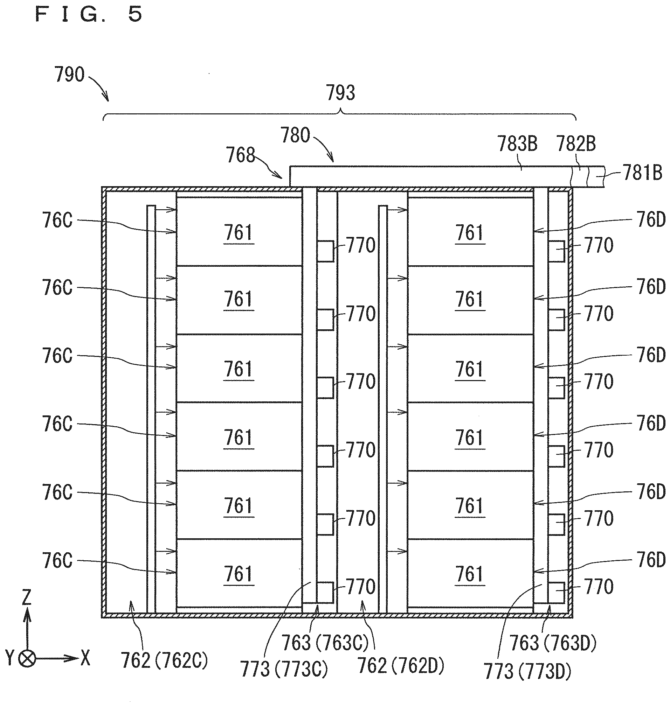

FIG. 3 is a vertical cross-sectional view schematically illustrating a vertical cross-section taken along a line III-III in FIG. 1 when one views the substrate treatment equipment 790 in the rear direction (+X direction). FIG. 4 is a side view schematically illustrating an example structure of a portion in the left (-Y direction; also referred to as a left portion) of the treatment block 793 viewed in the left direction (-Y direction). FIG. 5 is a side view schematically illustrating an example structure of a portion in the right (+Y direction; also referred to as a right portion) of the treatment block 793 viewed in the right direction (+Y direction).

As illustrated in FIGS. 1 to 5, the treatment block 793 includes, for example, two transport spaces 74A and 74B, two second transport mechanisms 75A and 75B, a plurality of (24 herein) treatment units 76, two substrate placement parts 77A and 77B, a partition 73w, and a horizontal exhaust system 780.

The transport space 74A is located in a central portion of the treatment block 793 in the width direction (±Y direction). The transport space 74A extends in the front and rear direction (±X direction). A forward portion of the transport space 74A (also referred to as a front portion) is coupled to the transport space 722 of the indexer 792.

The transport space 74B has a shape approximately identical to that of the transport space 74A. Specifically, the transport space 74B is located in a central portion of the treatment block 793 in the width direction (±Y direction). The transport space 74B extends in the front and rear direction (±X direction). A forward portion of the transport space 74B (also referred to as a front portion) is coupled to the transport space 722 of the indexer 792.

The transport space 74B is located below the transport space 74A. The transport space 74B is positioned to overlap the transport space 74A in a plan view. When there is no distinction between the transport spaces 74A and 74B, these are simply referred to as transport spaces 74.

The partition 73w has, for example, a horizontal plate shape. The partition 73w is located below the transport space 74A, and is located above the transport space 74B. The partition 73w partitions the transport space 74A and the transport space 74B.

The substrate placement part 77A is located in the transport space 74A. The substrate placement part 77A is located in a front portion of the transport space 74A. The first transport mechanism 723 of the indexer 792 also accesses the substrate placement part 77A. One or more of the substrates W are placed on the substrate placement part 77A.

The substrate placement part 77B is located in the transport space 74B. The substrate placement part 77B is located below the substrate placement part 77A. The substrate placement part 77B is located in a front portion of the transport space 74B. The substrate placement part 77B is positioned to overlap the substrate placement part 77A in a plan view. The substrate placement part 77B is located in the same position as the substrate placement part 77A in a plan view.

The first transport mechanism 723 of the indexer 792 also accesses the substrate placement part 77B. One or more of the substrates Ware placed on the substrate placement part 77B. When there is no distinction between the substrate placement parts 77A and 77B, these are simply referred to as substrate placement parts 77.

The second transport mechanism 75A is located in the transport space 74A. The second transport mechanism 75A transports the substrates W. The second transport mechanism 75A accesses the substrate placement part 77A.

The second transport mechanism 75B is located in the transport space 74B. The second transport mechanism 75B transports the substrates W. The second transport mechanism 75B has the same structure as that of the second transport mechanism 75A. The second transport mechanism 75B accesses the substrate placement part 77B. When there is no distinction between the second transport mechanisms 75A and 75B, these are simply referred to as second transport mechanisms 75.

Each of the second transport mechanisms 75 includes a hand 751 and a hand driving part 752. The hand 751 supports the single substrate W in a horizontal orientation. The hand driving part 752 is coupled to the hand 751. The hand driving part 752 moves the hand 751 in the front and rear direction (±X direction), the width direction (±Y direction), and the upward and downward direction. The hand driving part 752 includes a plurality of electric motors.

Specifically, the hand driving part 752 includes, for example, two struts 752a, a vertical mover 752b, a horizontal mover 752c, a rotator 752d, and a front and back mover 752e.

The two struts 752a are fixed to, for example, the sides of the transport space 722. The two struts 752a are aligned in the front and rear direction (±X direction). Each of the struts 752a extends in the upward and downward direction.

The two struts 752a support the vertical mover 752b. The vertical mover 752b extends in the front and rear direction (±X direction), and spans between the two struts 752a. The vertical mover 752b moves in the upward and downward direction with respect to the two struts 752a.

The vertical mover 752b supports the horizontal mover 752c. The horizontal mover 752c moves in the front and rear direction (±X direction) with respect to the vertical mover 752b. The horizontal mover 752c moves in the front and rear direction (±X direction) between the two struts 752a.

The horizontal mover 752c supports the rotator 752d. The rotator 752d rotates relative to the horizontal mover 752c. The rotator 752d rotates about a rotation axis line A2. The rotation axis line A2 is a virtual line extending in the upward and downward direction.

The front and back mover 752e moves with respect to the rotator 752d. The front and back mover 752e reciprocates in a horizontal direction determined by an orientation of the rotator 752d. The front and back mover 752e is connected to the hand 751.

The hand driving part 752 implements translating the hand 751 in the upward and downward direction and in any horizontal direction, and rotationally moving the hand 751 about the rotation axis line A2.

Each of the 24 treatment units 76 subjects the substrate W transported by the second transport mechanism 75 to a predetermined treatment.

The treatment block 793 includes six treatment units 76A, six treatment units 76B, six treatment units 76C, and six treatment units 76D. When there is no distinction between the treatment units 76A, 76B, 76C, and 76D, these are simply referred to as the treatment units 76.

The six treatment units 76A are located in a stack manner in the upward and downward direction. In other words, the six treatment units 76A are aligned in a row in the upward and downward direction. The six treatment units 76B are located in a stack manner in the upward and downward direction. In other words, the six treatment units 76B are aligned in a row in the upward and downward direction. The six treatment units 76C are located in a stack manner in the upward and downward direction. In other words, the six treatment units 76C are aligned in a row in the upward and downward direction. The six treatment units 76D are located in a stack manner in the upward and downward direction. In other words, the six treatment units 76D are aligned in a row in the upward and downward direction.

The six treatment units 76A, the six treatment units 76B, the six treatment units 76C, and the six treatment units 76D are included in the aforementioned respective towers (four towers herein).

Six treatment chambers 761 in the six treatment units 76A are stacked in the upward and downward direction. Six treatment chambers 761 in the six treatment units 76B are stacked in the upward and downward direction. Six treatment chambers 761 in the six treatment units 76C are stacked in the upward and downward direction. Six treatment chambers 761 in the six treatment units 76D are stacked in the upward and downward direction.

The six treatment units 76A and the six treatment units 76B are located to the left (-Y direction) of the transport space 74A and the transport space 74B, respectively. The six treatment units 76A and the six treatment units 76B are aligned in the front and rear direction (±X direction) along the transport space 74A and the transport space 74B, respectively. The six treatment units 76B are located rearward (in the +X direction) of the six treatment units 76A.

The six treatment units 76C and the six treatment units 76D are located to the right (+Y direction) of the transport space 74A and the transport space 74B, respectively. The six treatment units 76C and the six treatment units 76D are aligned in the front and rear direction (±X direction) along the transport space 74A and the transport space 74B, respectively. The six treatment units 76D are located rearward (in the +X direction) of the six treatment units 76C.

The six treatment units 76A and the six treatment units 76C face each other across the transport space 74A and the transport space 74B. The six treatment units 76B and the six treatment units 76D face each other across the transport space 74A and the transport space 74B.

The second transport mechanism 75 accesses the holder 711 of the treatment unit 76. The second transport mechanism 75A located above the partition 73w transports the substrates W to upper 12 (4 × upper three tiers) treatment units 76 of the 24 treatment units 76, and transports the substrates W out of these upper 12 treatment units 76. The second transport mechanism 75B located below the partition 73w transports the substrates W to lower 12 (4 × lower three tiers) treatment units 76 of the 24 treatment units 76, and transports the substrates W out of these lower 12 treatment units 76.

### [1-3. Structure of treatment unit]

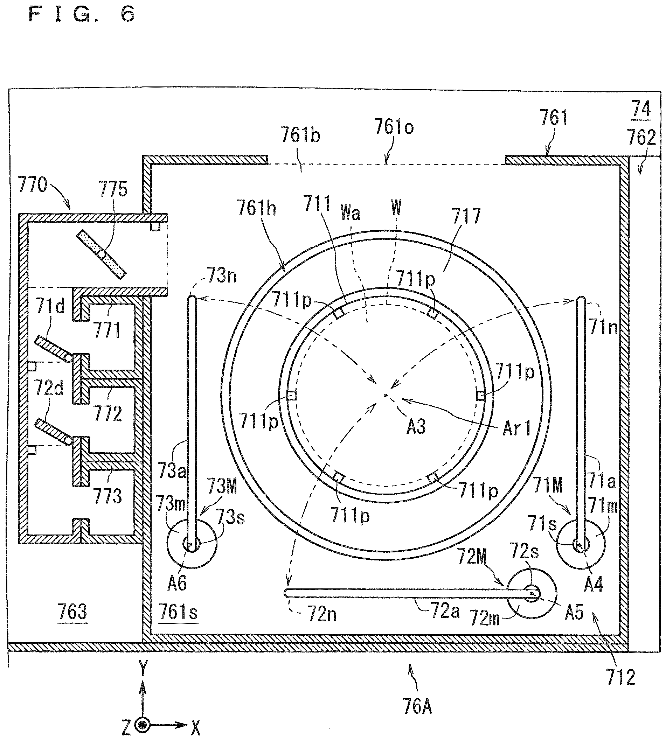

FIG. 6 is a lateral cross-sectional view schematically illustrating a structure of the treatment unit 76, using the treatment unit 76A as an example. Each of the treatment chambers 761 is adjacent to the transport space 74.

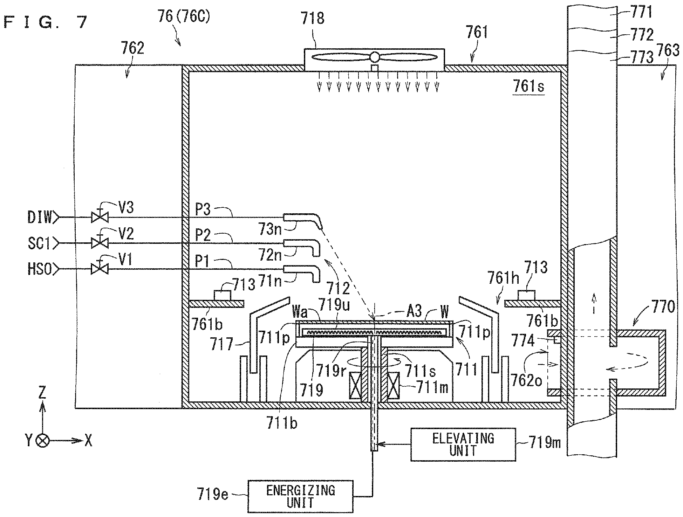

FIG. 7 is a lateral cross-sectional view schematically illustrating the structure of the treatment unit 76, using the treatment unit 76C as an example.

As illustrated in FIGS. 6 and 7, each of the treatment units 76 includes the treatment chamber 761 (also referred to as a chamber or a treatment container), a supply pipe space 762, and an exhaust pipe space 763. For example, the plurality of treatment units 76 have the same structure.

### [1-4. Structure of treatment chamber]

The treatment chamber 761 is, for example, approximately box-shaped. The treatment chamber 761 is of, for example, an approximately rectangular shape in a plan view, a front view, and a side view. The treatment chamber 761 includes a treatment space 761s inside the treatment chamber 761. The treatment unit 76 treats the substrate W in the treatment space 761s. FIG. 6 illustrates, using a broken line, an outer edge of the substrate W held by the holder 711.

The treatment chamber 761 includes a substrate outlet 761o closer to the transport space 74. The substrate outlet 761o is formed in a sidewall of the treatment chamber 761. The substrate outlet 761o is sized to allow the substrate W to pass therethrough. The second transport mechanism 75 transports the substrates W through the substrate outlet 761o between the outside of the treatment chamber 761 (specifically, the transport space 74) and the inside of the treatment chamber 761 (specifically, the treatment space 761s). Each of the treatment units 76 includes a shutter (not illustrated) that opens and closes the substrate outlet 761o.

Each of the treatment units 76 includes, for example, the holder 711 and a fluid supplier 712.

The holder 711 is located inside the treatment chamber 761. The holder 711 holds the substrate W. Specifically, the holder 711 holds the single substrate W in a horizontal orientation. The holder 711 includes, for example, a part (also referred to as a driver) that rotates the substrate W held by this holder 711 about a rotation axis line A3 that is virtual along the vertical direction.

A spin chuck is used as the holder 711. The spin chuck, for example, rotates the substrate W about the rotation axis line A3 passing through a central portion of the substrate W and extending in the upward and downward direction.

Specifically, the spin chuck includes chuck pins (chuck parts) 711p, a spin base 711b, a rotation shaft 711s coupled to the center of the lower surface of the spin base 711b, and an electric motor 711m as a driver that applies a rotational force to the rotation shaft 711s.

The rotation shaft 711s extends along the rotation axis line A3 in the upward and downward direction. The rotation shaft 711s is, for example, a hollow shaft.

The spin base 711b is coupled to the upper end of the rotation shaft 711s. The spin base 711b is disk-shaped in the horizontal direction. The spin base 711b is circular about the rotation axis line A3 in a plan view, and has a diameter larger than that of the substrate W. The plurality of (e.g., six) chuck pins 711p are located at intervals in a circumferential direction in a peripheral portion of the upper surface of the spin base 711b.

The plurality of chuck pins 711p can be opened and closed between a closed state of holding the substrate W in contact with a circumferential edge of the substrate W and an opened state of retracting from the circumferential edge of the substrate W. The plurality of chuck pins 711p, for example, support the substrate W from the bottom while coming in contact with the lower surface of a peripheral portion of the substrate W in the opened state.

For example, a linkage mechanism included in the spin base 711b and a unit including a driving source located outside of the spin base 711b drive opening and closing of the chuck pins 711p. The driving source includes, for example, a ball screw mechanism and an electric motor that applies a driving force to this ball screw mechanism.

Each of the treatment units 76 includes, for example, a heater unit 719. The heater unit 719 is located above the spin base 711b. An elevating axis 719r extending along the rotation axis line A3 in the upward and downward direction is coupled to the lower surface of the heater unit 719.

The elevating axis 719r is inserted into a through hole penetrating a central portion of the spin base 711b in the upward and downward direction and a hollow part of the rotation shaft 711s extending in the upward and downward direction.

The lower end of the elevating axis 719r extends downward over the lower end of the rotation shaft 711s. An elevating unit 719m is coupled to the lower end of the elevating axis 719r. Operating the elevating unit 719m causes the heater unit 719 to move up and down between a down position closer to the upper surface of the spin base 711b and an up position at which the heater unit 719 lifts the substrate W from the chuck pins 711p while supporting the lower surface of the substrate W.

The elevating unit 719m includes, for example, a ball screw mechanism and an electric motor that applies a driving force to this ball screw mechanism. Accordingly, the elevating unit 719m can dispose the heater unit 719 at any middle position between the down position and the up position.

For example, radiant heat from a heating surface 719u, which is the upper surface of the heater unit 719, can heat the substrate W while the heating surface 719u is disposed in a separating position at a predetermined distance from the lower surface of the substrate W. For example, when the heater unit 719 lifts the substrate W, the substrate W is heated with a greater amount of heat in a contact state where the heating surface 719u comes in contact with the lower surface of the substrate W, through thermal conduction from the heating surface 719u.

The heater unit 719 is shaped like a circular hot plate. The heater unit 719 includes a plate body, a plurality of support pins, and a heater. The upper surface of the plate body is a plane along a horizontal plane. The plate body is of a circular shape in a plan view similar to the substrate W, and has a diameter slightly smaller than that of the substrate W.

An outer circumferential edge of the plate body is located inside the plurality of chuck pins 711p. In other words, the plurality of chuck pins 711p surround the plate body in the horizontal direction. This prevents the heater unit 719 from interfering with the chuck pins 711p when the heater unit 719 moves up and down.

The support pins are, for example, respective hemisphere-like pins slightly protruding upward from the upper surface of the plate body. The plurality of support pins are almost equally spaced on the upper surface of the plate body. The plurality of support pins need not be disposed on the upper surface (the heating surface 719u) of the plate body.

For example, when the plurality of substrates W are supported in contact with the support pins, the lower surface of the substrates W faces the upper surface (the heating surface 719u) of the plate body at a minute distance. This enables the heater unit 719 to heat the substrates W efficiently and uniformly.

For example, a resistive body included in the plate body is used as the heater. For example, energizing the heater can heat the upper surface (the heating surface 719u) of the plate body to a temperature higher than boiling points of organic solvents. A feeder to the heater is inserted into the elevating axis 719r. Then, an energizing unit 719e that supplies power to the heater is connected to the feeder.

Each of the treatment units 76 includes, for example, a tubular cup 717 surrounding the holder 711 inside the treatment chamber 761.

The fluid supplier 712 supplies, for example, fluids of a plurality of kinds to the substrates W held by the holder 711. Examples of the fluids of the plurality of kinds include treatment liquids such as chemical solutions, rinse liquids, and organic solvents. Examples of the chemical solutions include etching solutions and cleaning fluids. For example, acidic solutions (acid liquids) and alkaline solutions (alkaline liquids) are used as the chemical solutions.

Examples of the acidic solutions include at least one of fluoric acid (hydrofluoric acid), hydrochloric acid hydrogen peroxide mixture (SC2), sulfuric acid, sulfuric acid hydrogen peroxide mixture (SPM), fluonitric acid (a mixed solution of hydrofluoric acid and nitric acid), or hydrochloric acid.

Examples of the alkaline solutions include at least one of ammonia hydrogen peroxide mixture (SC1), aqueous ammonia, ammonium fluoride solution, or tetramethylammonium hydroxide (TMAH).

The rinse liquids are, for example, liquids for flushing a chemical solution on the substrate W. For example, deionized water (DIW) is used as a rinse liquid.

The organic solvents are, for example, liquids for removing a rinse liquid on the substrate W. For example, isopropyl alcohol (IPA) is used as an organic solvent.

Examples of the plurality of fluids include gas such as inert gas. For example, nitrogen gas is used as the inert gas.

The fluid supplier 712 includes, for example, a first moving nozzle 71n, a second moving nozzle 72n, and a third moving nozzle 73n each of which ejects a predetermined fluid.

A first moving unit 71M moves the first moving nozzle 71n in the horizontal direction. With the movement in the horizontal direction, the first moving nozzle 71n can be moved between a position facing the rotation center of the upper surface Wa of the substrate W held by the holder 711 (hereinafter referred to as a "first ejection position") and a position not facing the upper surface Wa of the substrate W held by the holder 711 (hereinafter referred to as a "first home position").

The first ejection position may be, for example, a position from which the first moving nozzle 71n ejects a first treatment liquid so that the first treatment liquid sits on the rotation center of the upper surface of the substrate W. The first home position is a position outside the holder 711 in a plan view. Specifically, the first home position may be a position outside the cup 717 in a plan view.

The movement of the first moving unit 71M in the upward and downward direction may bring the first moving nozzle 71n closer to the upper surface Wa of the substrate W held by the holder 711, or retract the first moving nozzle 71n upward from the upper surface Wa of the substrate W held by the holder 711.

The first moving unit 71M includes, for example, a first pivot axis 71s extending in the upward and downward direction, a first arm 71a coupled to the first pivot axis 71s and extending horizontally, and a first arm driving mechanism 71m driving the first arm 71a.

The first arm driving mechanism 71m pivots the first arm 71a by rotating the first pivot axis 71s about a virtual pivot axis line A4 extending along the upward and downward direction. The first moving nozzle 71n is attached to a portion of the first arm 71a which is distant from the pivot axis line A4 in the horizontal direction.

Pivoting the first arm 71a causes the first moving nozzle 71n to move along an arc-shaped trajectory in the horizontal direction, as indicated by a double dot-dashed arrow in FIG. 6. The first arm driving mechanism 71m may, for example, move the first arm 71a up and down by elevating the first pivot axis 71s in the upward and downward direction.

The first moving nozzle 71n has a function of supplying a primary treatment liquid (also referred to as the first treatment liquid) to the upper surface Wa of the substrate W held by the holder 711. A first treatment liquid supply pipe P1 functioning as a pipe that supplies the first treatment liquid is coupled to the first moving nozzle 71n.

A first treatment liquid on-off valve V1 functioning as a valve that opens and closes a flow passage of the first treatment liquid supply pipe P1 is interposed in the first treatment liquid supply pipe P1. A treatment liquid distributor 701 or a treatment liquid distributor 702 to be described later supplies the first treatment liquid to the first treatment liquid supply pipe P1. Here, an acidic solution such as sulfuric acid (HSO) is used as the first treatment liquid. The first moving nozzle 71n may be a straight nozzle that ejects the first treatment liquid, or a two-fluid nozzle that mixes the first treatment liquid with inert gas and ejects the mixture.

A second moving unit 72M moves the second moving nozzle 72n in the horizontal direction. With the movement in the horizontal direction, the second moving nozzle 72n can be moved between a position facing the rotation center of the upper surface Wa of the substrate W held by the holder 711 (hereinafter referred to as a "second ejection position") and a position not facing the upper surface Wa of the substrate W held by the holder 711 (hereinafter referred to as a "second home position").

The second ejection position may be, for example, a position from which the second moving nozzle 72n ejects a second treatment liquid so that the second treatment liquid sits on the rotation center of the upper surface of the substrate W. The second home position is a position outside the holder 711 in a plan view. Specifically, the second home position may be a position outside the cup 717 in a plan view.

The movement of the second moving unit 72M in the upward and downward direction may bring the second moving nozzle 72n closer to the upper surface Wa of the substrate W held by the holder 711, or retract the second moving nozzle 72n upward from the upper surface Wa of the substrate W held by the holder 711.

The second moving unit 72M includes, for example, a second pivot axis 72s extending in the upward and downward direction, a second arm 72a coupled to the second pivot axis 72s and extending horizontally, and a second arm driving mechanism 72m driving the second arm 72a.

The second arm driving mechanism 72m pivots the second arm 72a by rotating the second pivot axis 72s about a virtual pivot axis line A5 extending along the upward and downward direction. The second moving nozzle 72n is attached to a portion of the second arm 72a which is distant from the pivot axis line A5 in the horizontal direction.

Pivoting the second arm 72a causes the second moving nozzle 72n to move along an arc-shaped trajectory in the horizontal direction, as indicated by a double dot-dashed arrow in FIG. 6. The second arm driving mechanism 72m may, for example, move the second arm 72a up and down by elevating the second pivot axis 72s in the upward and downward direction.

The second moving nozzle 72n has a function of supplying a secondary treatment liquid (also referred to as the second treatment liquid) to the upper surface Wa of the substrate W held by the holder 711. A second treatment liquid supply pipe P2 functioning as a pipe that supplies the second treatment liquid is coupled to the second moving nozzle 72n.

A second treatment liquid on-off valve V2 functioning as a valve that opens and closes a flow passage of the second treatment liquid supply pipe P2 is interposed in the second treatment liquid supply pipe P2. The treatment liquid distributor 701 or the treatment liquid distributor 702 to be described later supplies the second treatment liquid to the second treatment liquid supply pipe P2. Here, an alkaline solution such as ammonia hydrogen peroxide mixture (SC1) is used as the second treatment liquid. The second moving nozzle 72n may be a straight nozzle that ejects the second treatment liquid, or a two-fluid nozzle that mixes the second treatment liquid with inert gas and ej ects the mixture.

A third moving unit 73M moves the third moving nozzle 73n in the horizontal direction. With the movement in the horizontal direction, the third moving nozzle 73n can be moved between a position facing the rotation center of the upper surface Wa of the substrate W held by the holder 711 (hereinafter referred to as a "third ejection position") and a position not facing the upper surface Wa of the substrate W held by the holder 711 (hereinafter referred to as a "third home position").

The third ejection position may be, for example, a position from which the third moving nozzle 73n ejects a third treatment liquid so that the third treatment liquid sits on the rotation center of the upper surface of the substrate W. The third home position is a position outside the holder 711 in a plan view. Specifically, the third home position may be a position outside the cup 717 in a plan view.

The movement of the third moving unit 73M in the upward and downward direction may bring the third moving nozzle 73n closer to the upper surface Wa of the substrate W held by the holder 711, or retract the third moving nozzle 73n upward from the upper surface Wa of the substrate W held by the holder 711.

The third moving unit 73M includes, for example, a third pivot axis 73s extending in the upward and downward direction, a third arm 73a coupled to the third pivot axis 73s and extending horizontally, and a third arm driving mechanism 73m driving the third arm 73a.

The third arm driving mechanism 73m pivots the third arm 73a by rotating the third pivot axis 73s about a virtual pivot axis line A6 extending along the upward and downward direction. The third moving nozzle 73n is attached to a portion of the third arm 73a which is distant from the pivot axis line A6 in the horizontal direction.

Pivoting the third arm 73a causes the third moving nozzle 73n to move along an arc-shaped trajectory in the horizontal direction, as indicated by a double dot-dashed arrow in FIG. 6. The third arm driving mechanism 73m may, for example, move the third arm 73a up and down by elevating the third pivot axis 73s in the upward and downward direction.

The third moving nozzle 73n has a function of supplying a tertiary treatment liquid (also referred to as the third treatment liquid) to the upper surface Wa of the substrate W held by the holder 711. A third treatment liquid supply pipe P3 functioning as a pipe that supplies the third treatment liquid is coupled to the third moving nozzle 73n.

A third treatment liquid on-off valve V3 functioning as a valve that opens and closes a flow passage of the third treatment liquid supply pipe P3 is interposed in the third treatment liquid supply pipe P3. The treatment liquid distributor 701 or the treatment liquid distributor 702 to be described later supplies the third treatment liquid to the third treatment liquid supply pipe P3. Here, a rinse liquid such as deionized water (DIW) is used as the third treatment liquid. The third moving nozzle 73n may be a straight nozzle that ejects the third treatment liquid, or a two-fluid nozzle that mixes the third treatment liquid with inert gas and ejects the mixture.

The treatment unit 76 includes, for example, a fan filter unit (FFU) as an air supplier 718. The FFU can clean the air even in a clean room in which the substrate treatment equipment 790 is disposed, and supply the cleaned air to the treatment chamber 761.

The FFU is attached to, for example, a ceiling wall of the treatment chamber 761. The FFU includes a fan and a filter (e.g., a HEPA filter) that draws in the air in the clean room and delivers the air to the treatment chamber 761, so that a downflow of the cleaned air can be formed in the treatment chamber 761. A punching plate with many blow outlets may be disposed immediately below the ceiling wall to distribute the cleaned air supplied from the FFU more uniformly to the treatment chamber 761.

For example, an exhaust outlet 762o connected in communication with the outside of the substrate treatment equipment 790 (an exhaust facility of a factory, etc.,) is formed in the vicinity of a floor wall of the treatment chamber 761. The vicinity is a part of a side wall of the treatment chamber 761. For example, the air passing through the vicinity of, for example, the cup 717 in the cleaned air supplied from the FFU and flowing down inside the treatment chamber 761 is ejected outside the substrate treatment equipment 790 through the exhaust outlet 762o. For example, a structure of introducing inert gas such as nitrogen gas may be added to an upper portion of the treatment chamber 761.

### [1-5. Structure of supply pipe spaces]

As illustrated in FIGS. 4 and 5, four supply pipe spaces 762 extend in the upward and downward direction. For example, the supply pipe space 762A extends in the upward and downward direction from the treatment unit 76A at the bottom tier (a first tier) to the treatment unit 76A at the top tier (a sixth tier). For example, the supply pipe space 762B extends in the upward and downward direction from the treatment unit 76B at the bottom tier (the first tier) to the treatment unit 76B at the top tier (the sixth tier). For example, the supply pipe space 762C extends in the upward and downward direction from the treatment unit 76C at the bottom tier (the first tier) to the treatment unit 76C at the top tier (the sixth tier). For example, the supply pipe space 762D extends in the upward and downward direction from the treatment unit 76D at the bottom tier (the first tier) to the treatment unit 76D at the top tier (the sixth tier). When there is no distinction between the supply pipe spaces 762A to 62D, these are simply referred to the supply pipe spaces 762.

The supply pipe spaces 762 are regions in which pipes for supplying fluids to the treatment chambers 761 are disposed. For example, the first treatment liquid supply pipe P1, the second treatment liquid supply pipe P2, the third treatment liquid supply pipe P3, the first treatment liquid on-off valve V1, the second treatment liquid on-off valve V2, and the third treatment liquid on-off valve V3 are disposed in each of the supply pipe spaces 762. The first treatment liquid supply pipe P1, the second treatment liquid supply pipe P2, and the third treatment liquid supply pipe P3 are drawn from the supply pipe space 762 into the treatment chamber 761, and are connected to the first moving nozzle 71n, the second moving nozzle 72n, and the third moving nozzle 73n, respectively.

### [1-6. Structure of exhaust pipe spaces]

As illustrated in FIGS. 4 and 5, four exhaust pipe spaces 763 extend in the upward and downward direction. For example, the exhaust pipe space 763A extends in the upward and downward direction from the treatment unit 76A at the bottom tier (the first tier) to the treatment unit 76A at the top tier (the sixth tier). For example, the supply pipe space 763B extends in the upward and downward direction from the treatment unit 76B at the bottom tier (the first tier) to the treatment unit 76B at the top tier (the sixth tier). For example, the supply pipe space 763C extends in the upward and downward direction from the treatment unit 76C at the bottom tier (the first tier) to the treatment unit 76C at the top tier (the sixth tier). For example, the supply pipe space 763D extends in the upward and downward direction from the treatment unit 76D at the bottom tier (the first tier) to the treatment unit 76D at the top tier (the sixth tier). When there is no distinction between the exhaust pipe spaces 763A to 63D, these are simply referred to as the exhaust pipe spaces 763.

The exhaust pipe spaces 763 are regions in which pipes for discharging gas from the treatment chambers 761 are disposed. As illustrated in FIGS. 4 to 7, for example, an exhaust duct switching mechanism 770, a first vertical exhaust pipe 771, a second vertical exhaust pipe 772, and a third vertical exhaust pipe 773 are disposed in each of the exhaust pipe spaces 763.

For example, the exhaust duct switching mechanism 770 is disposed in the exhaust pipe space 763A for each of the treatment chambers 761 from the treatment unit 76A at the bottom tier (the first tier) to the treatment unit 76A at the top tier (the sixth tier). For example, the exhaust duct switching mechanism 770 is disposed in the exhaust pipe space 763B for each of the treatment chambers 761 from the treatment unit 76B at the bottom tier (the first tier) to the treatment unit 76B at the top tier (the sixth tier). For example, the exhaust duct switching mechanism 770 is disposed in the exhaust pipe space 763C for each of the treatment chambers 761 from the treatment unit 76C at the bottom tier (the first tier) to the treatment unit 76C at the top tier (the sixth tier). For example, the exhaust duct switching mechanism 770 is disposed in the exhaust pipe space 763D for each of the treatment chambers 761 from the treatment unit 76D at the bottom tier (the first tier) to the treatment unit 76D at the top tier (the sixth tier).

The number of sets of the first vertical exhaust pipe 771, the second vertical exhaust pipe 772, and the third vertical exhaust pipe 773 is, for example, four. The first vertical exhaust pipe 771, the second vertical exhaust pipe 772, and the third vertical exhaust pipe 773 are, for example, pipes for discharging the gas discharged from the treatment chamber 761 outside the substrate treatment equipment 790 through the exhaust duct switching mechanism 770.

For example, the first vertical exhaust pipe 771, the second vertical exhaust pipe 772, and the third vertical exhaust pipe 773 in each of the exhaust pipe spaces 763 extend from the side of the treatment chamber 761 at the bottom tier (the first tier) to the side of the treatment chamber 761 at the top tier (the sixth tier). In each of the exhaust pipe spaces 763, for example, the first vertical exhaust pipe 771, the second vertical exhaust pipe 772, and the third vertical exhaust pipe 773 are aligned in the width direction (±Y direction). In each of the exhaust pipe spaces 763, the first vertical exhaust pipe 771, the second vertical exhaust pipe 772, and the third vertical exhaust pipe 773 have a function of discharging the gas flowing from each of the treatment chambers 761 of the treatment units 76 of the six tiers stacked in the upward and downward direction, through the exhaust duct switching mechanism 770.

When the first vertical exhaust pipes 771 are distinguished between the treatment units 76A to 76D, the first vertical exhaust pipes 771 will be referred to as first vertical exhaust pipes 771A to 771D. When the second vertical exhaust pipes 772 are distinguished between the treatment units 76A to 76D, the second vertical exhaust pipes 772 will be referred to as second vertical exhaust pipes 772A to 772D. When the third vertical exhaust pipes 773 are distinguished between the treatment units 76A to 76D, the third vertical exhaust pipes 773 will be referred to as third vertical exhaust pipes 773A to 773D.

The first set (first group) of the first vertical exhaust pipe 771A, the second vertical exhaust pipe 772A, and the third vertical exhaust pipe 773A is configured to discharge gas from each of the treatment units 76A of the six tiers. The second set (second group) of the first vertical exhaust pipe 771B, the second vertical exhaust pipe 772B, and the third vertical exhaust pipe 773B is configured to discharge gas from each of the treatment units 76B of the six tiers. The third set (third group) of the first vertical exhaust pipe 771C, the second vertical exhaust pipe 772C, and the third vertical exhaust pipe 773C is configured to discharge gas from each of the treatment units 76C of the six tiers. The fourth set (fourth group) of the first vertical exhaust pipe 771D, the second vertical exhaust pipe 772D, and the third vertical exhaust pipe 773D is configured to discharge gas from each of the treatment units 76D of the six tiers.

The exhaust duct switching mechanism 770 is a mechanism for switching an exhaust duct of gas from the treatment chambers 761 to the outside of the substrate treatment equipment 790, to an exhaust duct through any one vertical exhaust pipe of the first vertical exhaust pipe 771, the second vertical exhaust pipe 772, and the third vertical exhaust pipe 773.

The exhaust duct switching mechanism 770 is disposed at lateral sides of the treatment chambers 761. The exhaust duct switching mechanism 770communicates, for example, with each of the treatment chambers 761 through the exhaust outlet 762o for discharging the gas in the treatment chamber 761. Furthermore, the exhaust duct switching mechanism 770 communicates, for example, with the first vertical exhaust pipe 771, the second vertical exhaust pipe 772, and the third vertical exhaust pipe 773 each extending in the upward and downward direction.

As illustrated in FIG. 6, the exhaust duct switching mechanism 770 includes, for example, a first opening and closing part 71d and a second opening and closing part 72d. Each of the first opening and closing part 71d and the second opening and closing part 72d has, for example, a door-like structure, and operates as a side-swinging door.

Each of the first opening and closing part 71d and the second opening and closing part 72d rotates about a pivot axis by driving, for example, a motor. For example, opening or closing the first opening and closing part 71d and the second opening and closing part 72d sets the exhaust duct switching mechanism 770 to any one of states, that is, a state of causing gas to flow from the treatment space 761s into the first vertical exhaust pipe 771 (also referred to as a first state), a state of causing gas to flow from the treatment space 761s into the second vertical exhaust pipe 772 (also referred to as a second state), and a state of causing gas to flow from the treatment space 761s into the third vertical exhaust pipe 773 (also referred to as a third state).

For example, during a period in which the first moving nozzle 71n ejects a first chemical solution, the exhaust duct switching mechanism 770 is set to the first state. For example, during a period in which the second moving nozzle 72n ejects a second chemical solution, the exhaust duct switching mechanism 770 is set to the second state. For example, during a period in which the third moving nozzle 73n ejects a third chemical solution, the exhaust duct switching mechanism 770 is set to the third state.

### [1-7. Structure of horizontal exhaust system]

As illustrated in FIGS. 3 to 5, the horizontal exhaust system 780 includes a first horizontal exhaust pipe 781A, a second horizontal exhaust pipe 782A, a third horizontal exhaust pipe 783A, a first horizontal exhaust pipe 781B, a second horizontal exhaust pipe 782B, a third horizontal exhaust pipe 783B.

As illustrated in FIGS. 3 and 4, for example, the first horizontal exhaust pipe 781A, the second horizontal exhaust pipe 782A, and the third horizontal exhaust pipe 783A are disposed above the two treatment units 76A and 76B at the top tier (the sixth tier) to extend in the front and rear direction (±X direction). The first horizontal exhaust pipe 781A, the second horizontal exhaust pipe 782A, and the third horizontal exhaust pipe 783A are, for example, aligned in the width direction (±Y direction).

For example, the first vertical exhaust pipe 771A for the treatment unit 76A and the first vertical exhaust pipe 771B for the treatment unit 76B are connected in communication with the first horizontal exhaust pipe 781A. The first horizontal exhaust pipe 781A discharges gas from the first vertical exhaust pipes 771A and 771B.

For example, the second vertical exhaust pipe 772A for the treatment unit 76A and the second vertical exhaust pipe 772B for the treatment unit 76B are connected in communication with the second horizontal exhaust pipe 782A. The second horizontal exhaust pipe 782A discharges gas from the second vertical exhaust pipes 772A and 772B.

For example, the third vertical exhaust pipe 773A for the treatment unit 76A and the third vertical exhaust pipe 773B for the treatment unit 76B are connected in communication with the third horizontal exhaust pipe 783A. The third horizontal exhaust pipe 783A discharges gas from the third vertical exhaust pipes 773A and 773B.

As illustrated in FIGS. 3 and 5, for example, the first horizontal exhaust pipe 781B, the second horizontal exhaust pipe 782B, and the third horizontal exhaust pipe 783B are disposed above the two treatment units 76C and 76D at the top tier (the sixth tier) to extend in the front and rear direction (±X direction). The first horizontal exhaust pipe 781B, the second horizontal exhaust pipe 782B, and the third horizontal exhaust pipe 783B are, for example, aligned in the width direction (±Y direction).

For example, each of the first vertical exhaust pipe 771C for the treatment unit 76C and the first vertical exhaust pipe 771D for the treatment unit 76D are connected in communication with the first horizontal exhaust pipe 781B. The first horizontal exhaust pipe 781B discharges gas from the first vertical exhaust pipes 771C and 771D.

For example, the second vertical exhaust pipe 772C for the treatment unit 76C and the second vertical exhaust pipe 772D for the treatment unit 76D are connected in communication with the second horizontal exhaust pipe 782B. The second horizontal exhaust pipe 782B discharges gas from the second vertical exhaust pipes 772C and 772D.

For example, the third vertical exhaust pipe 773C for the treatment unit 76C and the third vertical exhaust pipe 773D for the treatment unit 76D are connected in communication with the third horizontal exhaust pipe 783B. The third horizontal exhaust pipe 783B discharges gas from the third vertical exhaust pipes 773C and 773D.

The first horizontal exhaust pipe 781A, the second horizontal exhaust pipe 782A, and the third horizontal exhaust pipe 783A are longer than the first horizontal exhaust pipe 781B, the second horizontal exhaust pipe 782B, and the third horizontal exhaust pipe 783B.

The gas flows rearward (in the +X direction) inside each of the first horizontal exhaust pipe 781A, the second horizontal exhaust pipe 782A, the third horizontal exhaust pipe 783A, the first horizontal exhaust pipe 781B, the second horizontal exhaust pipe 782B, and the third horizontal exhaust pipe 783B.

The substrate treatment equipment 790 includes, for example, an exhaust part 768 including the four exhaust pipe spaces 763 and the horizontal exhaust system 780. This exhaust part 768 can discharge gas from the treatment chambers 761 to the outside of the substrate treatment equipment 790 (an exhaust facility of a factory, etc).

A treatment liquid storage 705 is disposed rearward (in the +X direction) of the substrate treatment equipment 790. The treatment liquid storage 705 stores the treatment liquid distributors 701 and 702, and treatment liquid supply sources 703 and 704. For example, the treatment liquid supply source 703 stores a chemical solution, and the treatment liquid supply source 704 stores a rinse liquid.

The treatment liquid distributors 701 and 702 obtain treatment liquids, specifically, the chemical solution from the treatment liquid supply source 703, and the rinse liquid from the treatment liquid supply source 704. The treatment liquid distributor 701 distributes the treatment liquid to the treatment units 76C and 76D. The treatment liquid distributor 702 distributes the treatment liquid to the treatment units 76A and 76B.

The pipes for supplying the treatment liquid from the treatment liquid distributor 701 to the treatment units 76C and the treatment units 76D are disposed in the supply pipe space 762C and the supply pipe space 762D, respectively. The pipes for supplying the treatment liquid from the treatment liquid distributor 702 to the treatment units 76A and the treatment units 76B are disposed in the supply pipe space 762A and the supply pipe space 762B, respectively.

### [1-8. Control system of substrate treatment equipment]

As illustrated in FIG. 1, for example, the substrate treatment equipment 790 includes a controller 79. The controller 79 is, for example, a part for controlling operations of each of the constituents of the substrate treatment equipment 790.

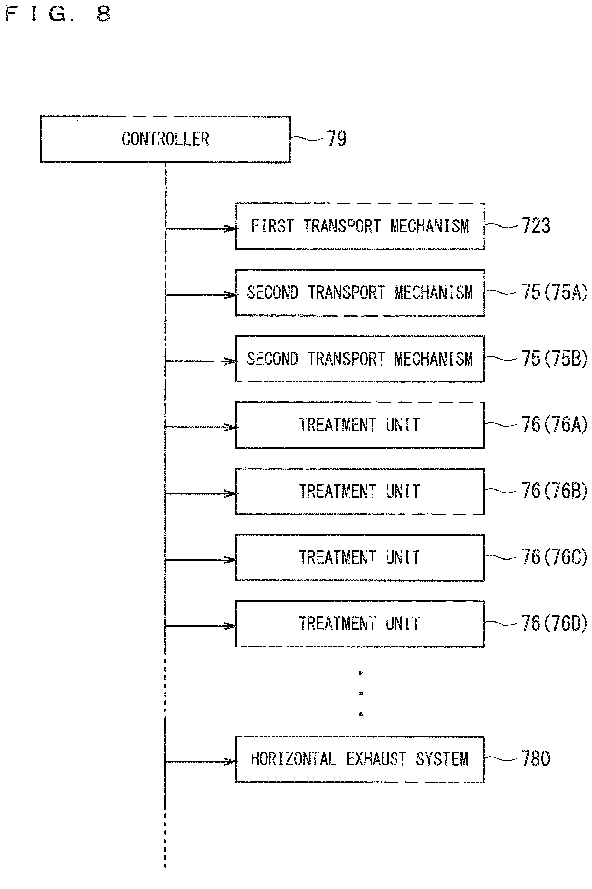

FIG. 8 is a block diagram illustrates a functional configuration for controlling the operations of each of the constituents of the substrate treatment equipment 790. The controller 79 is communicatively connected to the first transport mechanism 723, the second transport mechanisms 75, the plurality of treatment units 76, and the horizontal exhaust system 780.

Specifically, the controller 79 is communicatively connected to, for example, elements to be controlled in the plurality of treatment units 76 and the horizontal exhaust system 780. This enables the controller 79 to, for example, control operations of the first transport mechanism 723, the second transport mechanisms 75, the plurality of treatment units 76, and the horizontal exhaust system 780.

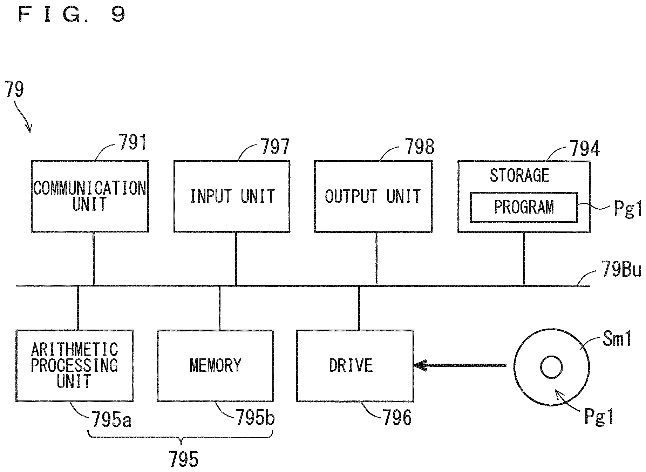

FIG. 9 is a block diagram illustrating one example configuration of the controller 79. The controller 79 is implemented by, for example, a common computer. The controller 79 includes, for example, a communication unit 791, an input unit 797, an output unit 798, a storage 794, a processing unit 795, and a drive 796 that are connected through a bus line 79Bu.

The communication unit 791, for example, transmits and receives a signal to and from each of the first transport mechanism 723, the second transport mechanisms 75, the plurality of treatment units 76, and the horizontal exhaust system 780 through a communication line. The communication unit 791 may, for example, receive a signal from a management server for managing the substrate treatment equipment 790.

The input unit 797 receives a signal corresponding to, for example, an operation of an operator. Examples of the input unit 797 include operating parts such as a mouse and a keyboard that can receive a signal corresponding to an operation, a microphone that can receive a signal corresponding to voice, and various sensors that can receive signals corresponding to movement.

The output unit 798 outputs, for example, various pieces of information in a format that can be recognized by the operator. Examples of the output unit 798 include a display that visibly outputs various pieces of information, and a speaker that audibly outputs various pieces of information. The display may be, for example, in the form of a touch panel integrated with at least a part of the input unit 797.

The storage 794 stores, for example, a program Pg1 and various pieces of information. The storage 794 includes, for example, a nonvolatile storage medium such as a hard disk or a flash memory. The storage 794 may have, for example, any one of a structure with a single storage medium, a structure of integrally having at least two storage media, and a structure with at least two parts separated from at least two storage media. The storage stores, for example, information on operating conditions of the first transport mechanism 723, the second transport mechanisms 75, the plurality of treatment units 76, and the horizontal exhaust system 780. Examples of the information on operating conditions of the treatment units 76 include a treatment recipe (a process recipe) for treating the substrates W.

The processing unit 795 includes, for example, an arithmetic processing unit 795a that functions as a processor, and a memory 795b as a work area for arithmetic processes. For example, an electronic circuit such as a central processing unit (CPU) is used as the arithmetic processing unit 795a. For example, a random access memory (RAM) is used as the memory 795b. The processing unit 795 implements functions of the controller 79, for example, by reading and executing the program Pg1 stored in the storage 794. In the controller 79, for example, the processing unit 795 performs the arithmetic processes according to the procedure written in the program Pg1 to implement various functional units that control operations of the elements of the substrate treatment equipment 790. In other words, the controller 79 included in the substrate treatment equipment 790 executes the program Pg1, so that functions and operations of the substrate treatment equipment 790 can be implemented. For example, a dedicated logic circuit may implement, hardware wise, a part or all the functional units implemented by the controller 79.

The drive 796 is, for example, a portion from which a transportable storage medium Sm1 can be detached. The drive 796 to which the storage medium Sm1 is attached causes this storage medium Sm1 and the processing unit 795 to exchange data. The drive 796 to which the storage medium Sm1 storing the program Pg1 is attached causes the storage medium Sm1 to read and store the program Pg1 in the storage 794.

Example operations of the whole substrate treatment equipment 790 will be described. For example, the substrate treatment equipment 790 controls the elements included in the substrate treatment equipment 790 according to a recipe in which, for example, a procedure of transporting the substrates W and treatment conditions have been written, so that a series of operations to be described below is performed.

Once the carrier C containing untreated substrates W are placed on the carrier placement part 721, the first transport mechanism 723 takes the untreated substrates W from this carrier C. The first transport mechanism 723 transports the untreated substrates W to the substrate placement parts 77. The second transport mechanisms 75 transport the untreated substrates W from the substrate placement parts 77 to the treatment units 76 designated according to, for example, the recipe. The substrates W may be transferred, for example, directly between the hand 7231 and the hand 751 without through the substrate placement parts 77, between the first transport mechanism 723 and the second transport mechanisms 75.

The treatment units 76 to which the substrates W have been transported execute a series of defined substrate treatments on the substrates W. In this series of substrate treatments, for example, a chemical solution and then a rinse liquid are supplied in this order onto the upper surface Wa of the substrate W held by the holder 711.

The treatment using the rinse liquid may be followed by supplying an organic solvent. After the treatment using the organic solvent, for example, the organic solvent is removed from the upper surface Wa of the substrate W to apply a treatment of drying the upper surface Wa of the substrate W (hereinafter also referred to as a "drying treatment"). In the drying treatment, for example, the electric motor 711m as a driver rotates the substrate W held by the holder 711 about the rotation axis line A3.

When this series of substrate treatments on the substrates W ends in the treatment units 76, the second transport mechanisms 75 take the treated substrates W from the treatment units 76. The second transport mechanisms 75 transport the treated substrates W to the substrate placement parts 77. The first transport mechanism 723 transports the substrates W from the substrate placement parts 77 to the carrier C on the carrier placement part 721.

In the substrate treatment equipment 790, the first transport mechanism 723 and the second transport mechanisms 75 repeatedly perform the aforementioned transport operations according to the recipe, and each of the treatment units 76 executes the series of substrate treatments on the substrate W according to the treatment recipe. Accordingly, the series of substrate treatments on the substrates W is performed one after another.

### [2. Description of circulation apparatus]

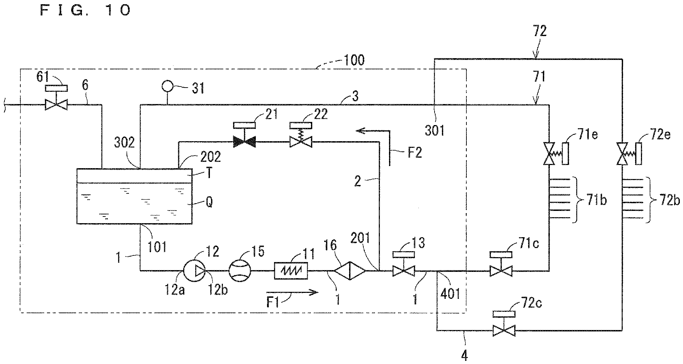

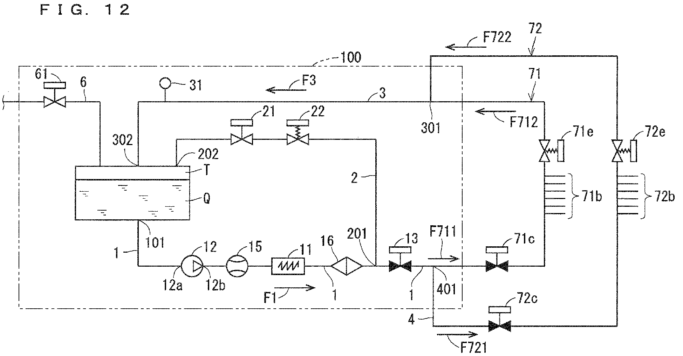

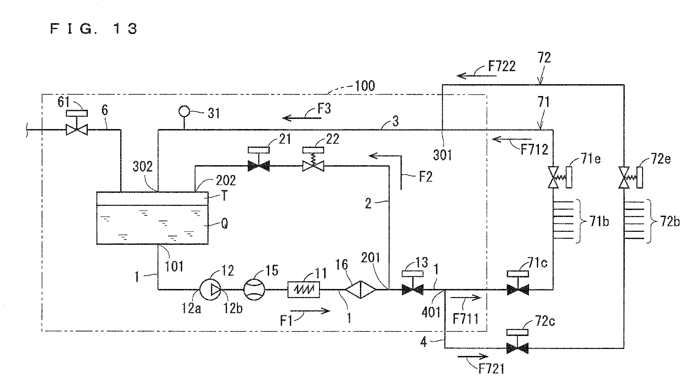

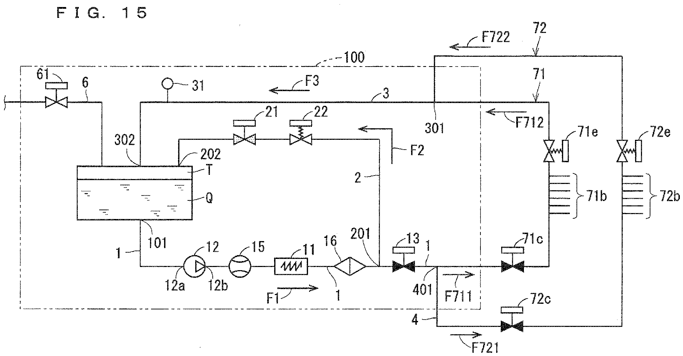

FIGS. 10, 12, 13, 15, 16, 18, and 19 are plumbing diagrams each exemplifying a structure of a circulation apparatus 100. FIG. 10 illustrates a state in which only the internal circulation is performed. FIG. 12 illustrates a state in which only the external circulation is performed. FIG. 13 illustrates a state in which the external circulation is performed together with the internal circulation. FIGS. 15, 16, 18, and 19 illustrate modified states, which will be described in detail later.

The circulation apparatus 100 can be employed as any of the treatment liquid distributors 701 and 702. FIG. 10 also illustrates external paths 71 and 72 connected to the circulation apparatus 100 from the outside of the circulation apparatus 100. The circulation apparatus 100 supplies and collects the treatment liquid to and from the external paths 71 and 72.

When the circulation apparatus 100 is employed as the treatment liquid distributor 701, for example, the external path 71 is a pipe through which a treatment liquid flows in the six treatment units 76C, and the external path 72 is a pipe through which a treatment liquid flows in the six treatment units 76D.

For example, the external path 71 supplies and collects the treatment liquid to and from the six treatment units 76C through a pipe 71b. For example, the external path 72 supplies and collects the treatment liquid to and from the six treatment units 76D through a pipe 72b. The pipe 71b is disposed in the supply pipe space 762C, and the pipe 72b is disposed in the supply pipe space 762D.

When the circulation apparatus 100 is employed as the treatment liquid distributor 702, for example, the external path 71 is a pipe through which a treatment liquid flows in the six treatment units 76A, and the external path 72 is a pipe through which a treatment liquid flows in the six treatment units 76B.

For example, the external path 71 supplies and collects the treatment liquid to and from the six treatment units 76A through the pipe 71b. For example, the external path 72 supplies and collects the treatment liquid to and from the six treatment units 76B through the pipe 72b. The pipe 71b is disposed in the supply pipe space 762A, and the pipe 72b is disposed in the supply pipe space 762B.

The circulation apparatus 100 includes a storage tank T. An object to be stored in the storage tank T is a liquid Q. The liquid Q is the aforementioned treatment liquid, for example, sulfuric acid or a dilution of sulfuric acid (dilute sulfuric acid).

The circulation apparatus 100 includes a pipe 1. The pipe 1 includes an inflow end 101 and is used for supplying the liquid Q to the external path 71. The liquid Q flows into the inflow end 101.

The circulation apparatus 100 includes a heater 11. The heater 11 is disposed in the pipe 1. An object to be heated by the heater 11 is the liquid Q.

The circulation apparatus 100 includes a pump 12. The pump 12 is disposed in the pipe 1. The pump 12 includes an inlet 12a and an outlet 12b. The inlet 12a is connected to the inflow end 101. An object to be expelled by the pump 12 from the inlet 12a to the outlet 12b is the liquid Q. The pump 12 is, for example, rotary. For example, a magnetic levitation centrifugal pump is employed as the pump 12. For example, a bearingless pump of Levitronix Technologies Inc. is employed as the magnetic levitation centrifugal pump.

The circulation apparatus 100 includes a valve 13. The valve 13 is disposed in the pipe 1. The valve 13 is connected to the outlet 12b through the heater 11. The valve 13 controls supply of the liquid Q to the external paths 71 and 72. For example, an on-off valve is employed as the valve 13.

The circulation apparatus 100 includes a pipe 2. The pipe 2 includes an inflow end 201 and an outflow end 202. The inflow end 201 is connected to the pipe 1 between the heater 11 and the valve 13. The liquid Q flows from the outflow end 202 to the storage tank T.

Valves 21 and 22 are disposed in the pipe 2. For example, an on-off valve or a regulation valve that regulates a flow rate is employed as the valve 21. For example, a relief valve is employed as the valve 22. A pressure loss value of the pipe 2 is variable due to an operation of the valve 21.

The circulation apparatus 100 includes pipes 3 and 4. The pipe 3 includes an outflow end 302. The pipe 3 is used for collecting the liquid Q from the external paths 71 and 72. Specifically, the pipe 3 includes an inflow end 301 at the opposite side of the outflow end 302. The pipe 3 is connected to the external paths 71 and 72 at the inflow end 301.

The circulation apparatus 100 includes the pipe 4. The pipe 4 includes an inflow end 401. The inflow end 401 is connected to the valve 13 on the opposite side of the heater 11. The pipe 4 is used for supplying the liquid Q to the external path 72.

A circulation in which the liquid Q flows from the storage tank T through the pipes 1, 3, and 4 and the valve 13 and the liquid Q flows into the storage tank T through the external path 71 and/or the external path 72 is referred to as the "external circulation". Since the liquid Q flows through the valve 13 in the external circulation, the valve 13 will also be referred to as an external circulation valve 13.

The circulation apparatus 100 includes a pipe 6. The pipe 6 is a path of the liquid Q to be stored in the storage tank T from the outside of the circulation apparatus 100. For example, when the circulation apparatus 100 is employed as the treatment liquid distributor 701, the pipe 6 is connected to the treatment liquid supply source 703. For example, when the circulation apparatus 100 is employed as the treatment liquid distributor 702, the pipe 6 is connected to the treatment liquid supply source 704.

A circulation in which the liquid Q flows from the storage tank T and the liquid Q flows into the storage tank T, through the pipes 1 and 2 and the valves 21 and 22 is referred to as the "internal circulation". Since the liquid Q flows through the valve 21 in the internal circulation, the valve 21 will also be referred to as an internal circulation valve 21.

The circulation apparatus 100 includes a filter 16. The filter 16 is disposed in the pipe 1, for example, between the heater 11 and the inflow end 201. The filter 16 has a function of removing impurities from the liquid Q.

The circulation apparatus 100 includes a flowmeter 15. The flowmeter 15 is disposed, for example, between the outlet 12b and the heater 11. The flowmeter 15 measures a flow rate of the liquid Q in the pipe 1.

The circulation apparatus 100 includes a thermometer 31. The thermometer 31 is disposed, for example, in the pipe 3 closer to the external paths 71 and 72 than the outflow end 302. The thermometer 31 measures a temperature of the liquid Q in the pipe 3.

A valve 71c is disposed in the external path 71 between the pipe 1 and the pipe 71b. A valve 72c is disposed in the external path 72 between the pipe 1 and the pipe 72b. For example, an on-off valve is employed as each of the valves 71c and 72c. In the external circulation, the valve 71c and the valve 72c are opened, so that the liquid Q is supplied from the pipe 1 to the external path 71 and from the pipe 4 to the external path 72, respectively.

The external paths 71 and 72 can be defined as paths of treatment liquids in the different towers. The valve 71c and the valve 72c are valves through which the liquid Q supplied from the circulation apparatus 100 to the external paths 71 and the external path 72, respectively, first passes. Thus, the valves 71c and the valve 72c are hereinafter also referred to as a tower source valve 71c and a tower source valve 72c, respectively.

A valve 71e is disposed in the external path 71 between the pipe 2 and the pipe 71b. A valve 72e is disposed in the external path 72 between the pipe 2 and the pipe 72b. The valves 71e and 72e are relief valves.

The circulation apparatus 100 includes a valve 61 disposed in the pipe 6. The valve 61 controls the liquid Q flowing to the storage tank T. For example, an on-off valve is employed as the valve 61.

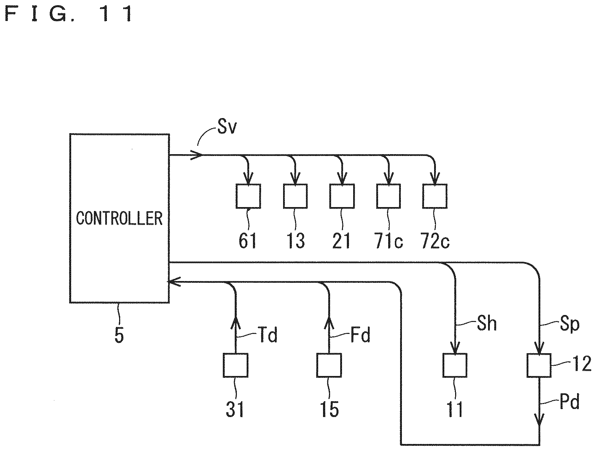

FIG. 11 is a block diagram illustrating an outline of functions of a controller 5. The controller 5 controls operations of the valves 13, 21, 71c, 72c, and 61. For example, the controller 5 provides control signals Sv to the valves 13, 21, 71c, 72c, and 61 to control opening and closing of these.

The controller 5 controls operations of the heater 11 and the pump 12. For example, the controller 5 provides a control signal Sh to the heater 11 to control heating of the liquid Q by the heater 11. For example, the controller 55 provides a control signal Sp to the pump 12 to control a flow velocity of the liquid Q to be supplied by the pump 12.

The controller 5 receives, from the flowmeter 15, data Fd indicating the flow rate of the liquid Q flowing through the pipe 1. The controller 5 receives, from the thermometer 31, data Td indicating the temperature of the liquid Q (hereinafter simply referred to as a "liquid temperature") in the pipe 3. The controller 5 receives, from the pump 12, data Pd indicating the current flowing through the pump 12. When a magnetic levitation centrifugal pump is employed as the pump 12, the data Pd indicates the current flowing through the pump 12 and/or a position of an impeller (hereinafter referred to as an "impeller position") of the magnetic levitation centrifugal pump.

A known technology is used for the controller 5 to control a rotation speed of the pump 12 using the control signal Sp based on the data Fd or to control heating of the liquid Q by the heater 11 using the control signal Sh based on the data Td. Thus, details on the technology for controlling the heater 11 or the pump 12 are omitted.

For example, a part or the entirety of the controller 79 can implement the controller 5. The controller 5 can also be understood as a part of the circulation apparatus 100.

The following will describe relations between three subjects, namely, operations of opening and closing of the valves, liquid temperatures, and states of the pump 12. In the following description, a pair of black triangles is used to represent a symbol of an opened valve, and a pair of triangles that are not filled is used to represent a symbol of a closed valve.

When the valve 21 functions as a regulation valve as will be described later, a pair of triangles illustrating the valve 21 is hatched with dots (hereinafter provisionally referred to as "dot-hatched").

A pair of triangles that are not filled and illustrate each of the valves 71e, 72e, and 22 as a relief valve represents a closed state indicating that the liquid Q is not relieved. Thus, the valve 71e, the valve 72e, and the valve 22 do not inhibit the liquid Q from flowing through the external path 71, the external path 72, and the pipe 2, respectively, in the following description.

When the valve 22 is used as a regulation valve as will be described later, a pair of triangles illustrating the valve 22 is dot-hatched.

The description on storing the liquid Q into the storage tank T will be omitted in the following description. Thus, a state in which the valve 61 is closed will be described.

### [2-1. Internal circulation]

Before a treatment liquid (the liquid Q herein) is supplied to the external paths 71 and 72, increasing the temperature of the treatment liquid to a predetermined temperature through the internal circulation contributes to managing the temperature of the treatment liquid when used in treatment. With reference to FIG. 10, the valves 13, 71c, and 72c are closed, and the valve 21 is opened in executing the internal circulation. The heater 11 heats the liquid Q.

In the internal circulation, the liquid Q passes from the storage tank T through the pump 12, the flowmeter 15, the heater 11, the filter 16, the inflow end 201, the valves 22 and 21, and the outflow end 202 in this order, and returns to the storage tank T. In the internal circulation, the heater 11 heats the liquid Q to a desired value.

In FIG. 10, a stream of the liquid Q (hereinafter referred to as a "liquid stream") F1 flows in the pipe 1 through the pump 12, the flowmeter 15, and the filter 16 in this order, and reaches the inflow end 201. In FIG. 10, a liquid stream F2 flows in the pipe 2 from the inflow end 201 through the valves 22 and 21 in this order, up to the outflow end 202. Since the valve 13 is closed, the liquid streams F1 and F2 are substantially continuous at the inflow end 201.

### [2-2. External circulation]

With reference to FIG. 12, the valves 13, 71c, and 72c are opened, and the valve 21 is closed in executing the external circulation. The treatment liquid (the liquid Q herein) is supplied to the external paths 71 and 72. The heater 11 heats the liquid Q.

In this embodiment, after the internal circulation is performed, only the external circulation is temporarily executed. This makes it easier to avoid a phenomenon of the external circulation involving the internal circulation in which the treatment liquid resists flowing through the external paths 71 and 72. It is because the liquid Q does not flow through the pipe 2 that is a path of the internal circulation.

In FIG. 12, the liquid stream F1 flows in the pipe 1 through the pump 12, the flowmeter 15, the heater 11, the filter 16, and the valve 13 in this order, and reaches the inflow end 401. In FIG. 12, the liquid stream F1 branches off to liquid streams F711 and F721. The liquid stream F711 flows into the external path 71, specifically, the valve 71c. The liquid stream F721 flows into the external path 72, specifically, the valve 72c.

The liquid stream F721 and the liquid stream F722 flow, into the inflow end 301, through the external path 71 and the external path 72, respectively. The liquid streams F721 and F722 merge at the inflow end 301 to flow, as a liquid stream F3, through the pipe 3. The liquid stream F3 flows from the inflow end 301 toward the outflow end 302.

### [2-3. External circulation involving internal circulation]

The external circulation without involving the internal circulation allows the temperature and the flow velocity of the liquid Q in each of the external paths 71 and 72 to reach respective desired values earlier. The heater 11 heats the liquid Q.

With reference to FIG. 13, the valves 13, 21, 71c, and 72c are opened when the external circulation involving the internal circulation is executed. The liquid Q is supplied to the external paths 71 and 72. During a period in which the external circulation involving the internal circulation is executed, the temperature and the flow velocity of the liquid Q in each of the towers become desired values. The treatment in the tower is normally performed during this period. In view of this, the external circulation involving the internal circulation will also be hereinafter referred to as a "tower circulation".

In FIG. 13, the liquid stream F1 flows in the pipe 1 through the pump 12, the flowmeter 15, the heater 11, and the filter 16 in this order, and reaches the inflow end 201. A part of the liquid stream F1 flows from the inflow end 201 through the pipe 2 as the liquid stream F2. The remaining part of the liquid stream F1 branches off to the liquid streams F711 and F721 at the inflow end 401.

The liquid stream F2 flows in the pipe 2 from the inflow end 201 through the valves 22 and 21 in this order, up to the outflow end 202.

The liquid stream F711 flows into the external path 71, specifically, the valve 71c. The liquid stream F721 flows into the external path 72, specifically, the valve 72c.

The liquid stream F721 and the liquid stream F722 flow, into the inflow end 301, through the external path 71 and the external path 72, respectively. The liquid streams F721 and F722 merge at the inflow end 301 to flow through the pipe 3 as the liquid stream F3. The liquid stream F3 flows from the inflow end 301 toward the outflow end 302.

### [2-4. Timing to start and end internal circulation]

The procedure of the internal circulation, the external circulation, and the external circulation involving the internal circulation (tower circulation) contributes to allowing the temperature and the velocity of the liquid Q in each of the external paths 71 and 72 to reach respective desired values earlier.

For example, when a liquid temperature reaches a predetermined temperature or higher (hereinafter referred to as an "internal circulation target temperature T1"), the internal circulation is switched to the external circulation. Such switching contributes to replacement of the treatment liquid remaining in each of the external paths 71 and 72 with a treatment liquid at a desired temperature in the external circulation to be executed next.

After it is estimated that the temperature of the treatment liquid flowing through each of the external paths 71 and 72 reaches the desired temperature and/or the desired temperature during execution of the external circulation, the internal circulation starts in parallel with the external circulation.

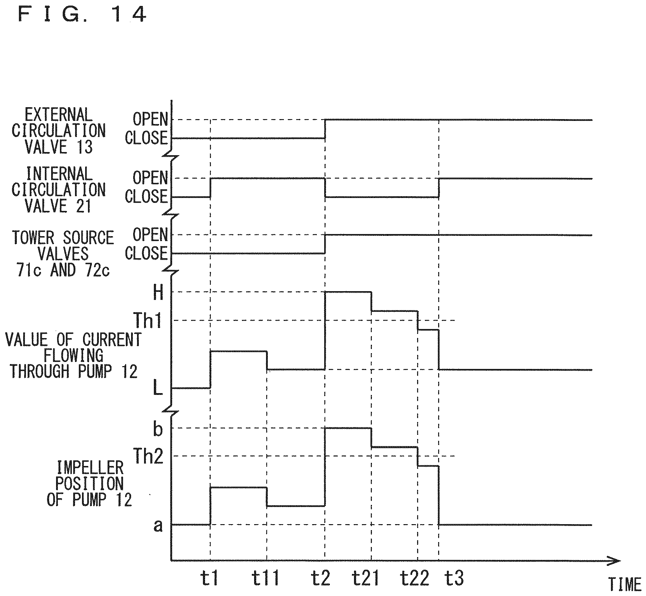

FIG. 14 is a timing chart exemplifying execution of the external circulation and the internal circulation. The horizontal axis represents the time. The vertical axis represents states of the external circulation valve 13, the internal circulation valve 21, and the tower source valves 71c and 72c, and a value of a current flowing through the pump 12. Furthermore, the vertical axis also represents the impeller position of the pump 12 when a magnetic levitation centrifugal pump is employed as the pump 12.

"OPEN" denotes opened states of the external circulation valve 13, the internal circulation valve 21, and the tower source valves 71c and 72c, whereas "CLOSE" denotes closed states of these valves. "H" and "L" each represent an indication of a value of a current flowing through the pump 12 (hereinafter referred to as a "pump current"). FIG. 14 illustrates a higher pump current as the graph is closer to the indication "H", and illustrates a lower pump current as the graph is closer to the indication "L". For example, the indication "L" indicates a state in which the pump current is zero and the pump 12 is terminated. As the viscosity of the liquid Q is higher, the pump current required to cause the liquid stream F1 to flow at a desired flow velocity is larger.

The impeller position is represented by indications "a" and "b". FIG. 14 illustrates that the impeller position is closer to the inlet 12a as the graph is closer to the indication "a", and that the impeller position is farther from the inlet 12a as the graph is closer to the indication "b". As the viscosity of the liquid Q is higher, the impeller is subjected to a higher load (pressure) from the inflow end 101, and its position is far from the inflow end 101.

The pump current and/or the impeller position are provided to the controller 5 as the data Pd. The temperature of the liquid Q is provided to the controller 5 as the data Td. The controller 5 controls the pump 12 and opening and closing of the valves 13, 21, 71c, and 72c based on the data Td and the data Pd.

At the time t1, the internal circulation, heating by the heater 11, and driving the pump 12 are started. At the time 11, the valve 21 is opened. Before the time 11, the valves 13, 71c, and 72c are closed, and the liquid Q is not supplied to the external paths 71 and 72 of the circulation apparatus 100. During a period from the time t1 to the time t2 (hereinafter referred to as a "first period"), a state in which the valves 13, 71c, and 72c are closed and the valve 21 is opened is maintained. This means that FIG. 10 illustrates a state of the circulation apparatus 100 during the first period.

In the beginning of the first period, the liquid temperature is low and the viscosity of the liquid Q is high. The heater 11 heats the liquid Q, so that the liquid temperature of the liquid Q increases and the viscosity decreases. Thus, the pump current rises at the time 11, and then decreases. At the time 11, the impeller position is far from the inlet 12a, and then approaches the inlet 12a. FIG. 14 exemplifies a case where the pump current decreases and the impeller position approaches the inlet 12a at the time t11 after the time t1 and before the time t2.

The time t2 is, for example, the time when the liquid temperature reaches the internal circulation target temperature T1. At the time t2, the external circulation is started. Heating by the heater 11 and driving the pump 12 are maintained. During a period from the time t2 to the time t3 (hereinafter referred to as a "second period"), a state in which the valves 13, 71c, and 72c are opened and the valve 21 is closed is maintained. This means that FIG. 12 illustrates a state of the circulation apparatus 100 during the second period.

In the beginning of the second period, the liquid temperature of the liquid Q remaining in the external paths 71 and 72 is low, and the viscosity of the liquid Q is high. The heater 11 heats the liquid Q, so that the liquid temperature of the liquid Q increases and the viscosity decreases. Thus, the pump current rises at the time t2 again, and then decreases. At the time t2, the impeller position is again far from the inlet 12a, and then approaches the inlet 12a. FIG. 14 exemplifies a case where the pump current decreases stepwise and the impeller position approaches the inlet 12a stepwise at the times t21 and t22 (> t21) after the time t2 and before the time t3.

Once it is detected during the second period that the pump current falls below a threshold Th1 and/or the impeller position is closer to the inlet 12a than a position Th2, the internal circulation is again executed while the external circulation is maintained. A period after the time t3 can be described as a third period during which the external circulation involving the internal circulation is performed. This means that FIG. 13 illustrates a state of the circulation apparatus 100 during the third period (in which the tower circulation is performed).

FIG. 14 exemplifies a case where the pump current falls below the threshold Th1 and the impeller position is closer to the inlet 12a than the position Th2 at the time t22, and the valve 21 is opened at the time t3 after the time t22. FIG. 14 exemplifies a case where the aforementioned detection is performed from the time t22 to the time t3. This means that the replacement completion time is between the time t22 and the time t3.

As such, once replacement of the treatment liquid remaining in each of the external paths 71 and 72 with the treatment liquid at a desired temperature is verified, the tower circulation is started. When the temperature of the treatment liquid in each of the external paths 71 and 72 reaches the desired temperature, the viscosity of the treatment liquid decreases, and the desired flow velocity is obtained.

### [2-5. First modification]

When the treatment liquid remaining in each of the external paths 71 and 72 is replaced with a treatment liquid to be supplied from the circulation apparatus 100, causing the treatment liquid to flow preferentially through a path in the internal circulation is one of factors for addressing the problem. In view of this factor, the external circulation without involving the internal circulation is not essential. For example, when the liquid Q resists flowing through the path in the internal circulation more than that in the internal circulation to be executed during the third period, the internal circulation may also be performed during the second period.

FIG. 15 exemplifies a case where the external circulation involving such internal circulation is performed during the second period. A valve that can regulate a flow rate of the liquid Q as well as switching between opening and closing is employed as the valve 21. A pair of triangles representing a symbol of the valve 21 is dot-hatched in FIG. 15, which indicates that the flow rate of the liquid Q is regulated. The degree of opening of the valve 21 during the second period is smaller than that during the third period. FIG. 12 can be regarded as illustrating a case where the degree of opening of the valve 21 is zero as a typical value. A pressure loss value of the pipe 2 in this case is significantly high.

Unlike the second period exemplified in FIG. 12, the liquid streams F1, F2, F3, F721, and F722 flow in FIG. 15, similarly to FIG. 13 exemplifying the third period. The liquid stream F2 during the second period is less than that during the third period.

Such a function of the valve 21 can be regarded as a function of adjusting the pressure loss value of the pipe 2. The valve 21 contributes to adjusting the pressure loss value of the pipe 2. The pressure loss value of the pipe 2 during the second period is higher than that during the second period.

With a focus on the pressure loss values, the operations illustrated in FIGS. 10, 12, 13, 14, and 15 can be described as below.

While the heater 11 heats the liquid Q:
the valve 13 is closed during the first period (the times t1 to t2) (a process J1);
the valve 13 is opened, and the pressure loss value of the pipe 2 is increased during the second period (the times t2 to t3) after the end of the first period (a process J2); and
the valve 13 is opened, and the pressure loss value of the pipe 2 is reduced during the third period (after the time t3) after the end of the second period (a process J3).

Specifically, controlling the valve 21 that is placed in the pipe 2 of the circulation apparatus 100 and can regulate the flow rate controls the pressure loss value of the pipe 2.

For example, when the load of the pump 12 transitions from a state larger than a predetermined value to a state smaller than the predetermined value, the second period ends and the third period starts.

Once replacement of the treatment liquid (the liquid Q) in the external paths 71 and 72 with the treatment liquid at a desired temperature or higher is verified, the second period ends and the third period starts. As the viscosity of the liquid Q is higher, the load of the pump 12 is higher. As the temperature of the liquid Q is lower, the viscosity of the liquid Q is higher. Thus, the load of the pump 12 and the temperature of the liquid Q have a negative correlation. Consequently, the control based on the load of the pump 12 contributes to ending the second period and starting the third period and/or ending the process J2 and starting the process J3.

The magnitude of the load of the pump 12 can be detected by the pump current. Specifically, as the load of the pump 12 is higher, the pump current is larger. The magnitude of the load of the pump 12 can also be detected by the impeller position. Specifically, as the load of the pump 12 is higher, the impeller position is farther from the inlet 12a. The controller 5 controls the valve 13 based on the data Pd, and executes the processes 11, J2, and J3.

Since the liquid Q collected from the external paths 71 and 72 flows through the pipe 3, the temperature to be measured by the thermometer 31 reflects the liquid temperature of the liquid Q collected from the external paths 71 and 72. Thus, a replacement completion time can be set using an increase in the temperature. For example, when the liquid temperature transitions from a temperature lower than a predetermined value to a temperature higher than the predetermined value, the second period ends and the third period starts. The controller 5 controls the valve 13 based on the data Td, and executes the processes 11, J2, and J3. The control based on the temperature to be measured by the thermometer 31 contributes to ending the second period and starting the third period and/or ending the process J2 and starting the process J3.

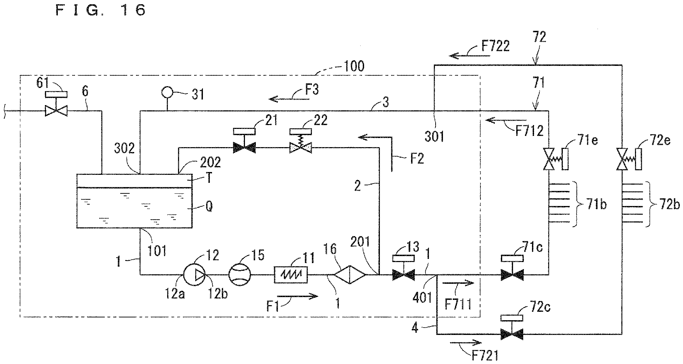

FIG. 16 exemplifies a case where the external circulation involving the internal circulation is performed and the pressure loss value of the pipe 2 during the second period is higher than that during the third period. An on-off valve is employed as the internal circulation valve 21. The internal circulation valve 21 is opened during the second period, similarly to the first and third periods. The degree of opening of the valve 22 differs from those of the first and third periods. The pressure loss value of the pipe 2 during the second period is increased more than that during the third period. A pair of triangles representing a symbol of the valve 22 is dot-hatched, which indicates that the flow rate of the liquid Q is regulated.

The description on the valve 21 in the structure exemplified in FIG. 15 applies to this structure by reading the valve 21 as the valve 22. The valve 22 contributes to adjusting the pressure loss value of the pipe 2.

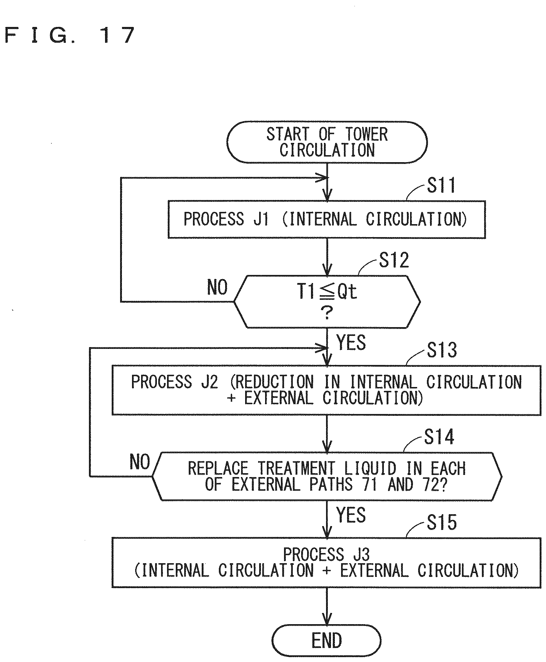

FIG. 17 is a flowchart exemplifying the operations according to the aforementioned embodiment and the first modification. Since these operations can be regarded as start of the tower circulation, this flowchart is titled "START OF TOWER CIRCULATION".

In Step S11, the process J1 is executed. In the aforementioned example, the internal circulation valve 21 is opened at the time 11. Then, whether the liquid temperature Qt of the liquid Q is higher than or equal to the internal circulation target temperature T1 is determined in Step S12. When the result of the determination is negative, the processes return to Step S11, and the process J1 is repeatedly executed.

When the liquid temperature Qt reaches the internal circulation target temperature T1 and the result of the determination in Step S12 is affirmative, the process J2 is executed in Step S13. In the flowchart, "REDUCTION IN INTERNAL CIRCULATION" indicates that the liquid Q internally circulated in the process J2 is less than that in the process J1. This is implemented by the increase in the pressure loss value of the pipe 2 as described above. In the aforementioned example, the internal circulation valve 21 is typically closed at the time t2.

Then, whether the treatment liquid in each of the external paths 71 and 72 has been replaced is determined in Step S14. In the aforementioned example, transition of the load of the pump 12 from the state larger than the predetermined value to the state smaller than the predetermined value gives the affirmative result to the determination.

Giving a more specific example, once it is detected that the pump current falls below the threshold Th1 after the time t2 (established on the premise that Step S13 and then Step S14 are executed), the result of the determination in Step S14 becomes affirmative.

Giving another specific example, once it is detected that the impeller position is closer to the inlet 12a than the position Th2 after the time t2 (established on the premise that Step S13 and then Step S14 are executed), the result of the determination in Step S14 becomes affirmative.

When the result of the determination in Step S14 is negative, the processes return to Step S13, and the process J2 is repeatedly executed.

When the result of the determination in Step S14 is affirmative, the process J3 is executed in Step S15. Specifically, the tower circulation is executed. Execution of Step S15 starts the tower circulation.

When compared to the first modification, employing the on-off valve as the valve 21 and closing the valve 21 during the second period are preferable in view of significantly increasing the pressure loss value of the pipe 2.

### [2-6. Second modification]

In the aforementioned exemplification, the external circulation (or the external circulation involving the internal circulation in which the flow rate of the liquid Q is restricted more than that in the tower circulation) is performed in any of the external paths 71 and 72 during the second period. It is assumed, however, that the treatment liquids remaining in the external paths 71 and 72 differ in, for example, the liquid temperature Qt. In such a case, the external circulation for the second period may be performed in the external paths 71 and 72 individually.

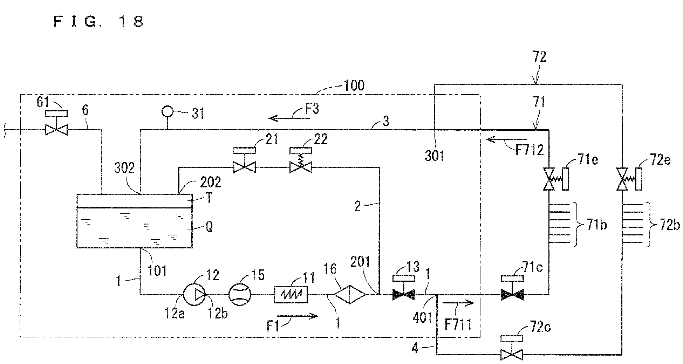

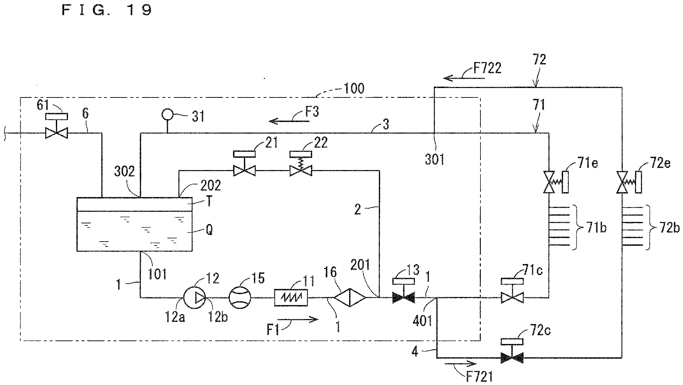

FIG. 18 illustrates the external circulation when the liquid Q is supplied to the external path 71 without supplying the liquid Q to the external path 72. FIG. 19 illustrates the external circulation when the liquid Q is supplied to the external path 72 without supplying the liquid Q to the external path 71.

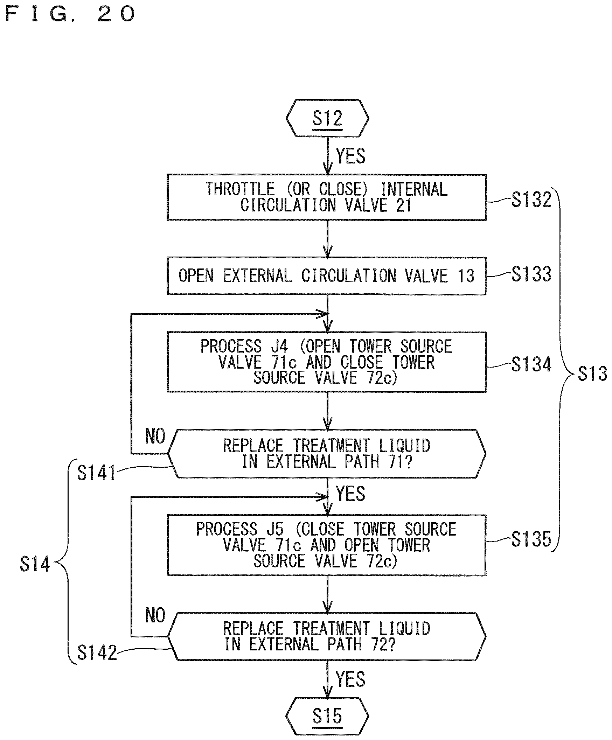

FIG. 20 is a flowchart partially exemplifying operations according to the second modification. Steps S13 and S14 in the flowchart of FIG. 17 are replaced with this flowchart to exemplify the operations according to the second modification.

In FIG. 20, it can be understood that Step S13 corresponding to the process J2 is divided into Steps S132, S134, and S135. In FIG. 20, it can be understood that Step S14 is divided into Steps S141 and S142.

When the determination in Step S12 (see FIG. 17) is affirmative, Step S132 is executed. The process to be executed in Step S132 is a process of throttling the internal circulation valve 21 (reducing the degree of opening of the internal circulation valve 21) or closing the internal circulation valve 21.

Then, the external circulation valve 13 is opened in Step S133, and the tower source valve 71c is opened in Step S134. The tower source valve 72c is closed. This implements the external circulation in the external path 71. Here, the external circulation in the external path 71 is exemplified as a process J4.

Then, whether the treatment liquid in the external path 71 has been replaced is determined in Step S141. The determination is made in the same manner as Step S14. When the result of the determination in Step S141 is negative, the processes return to Step S134, and the process J4 is repeatedly executed.

When the result of the determination in Step S141 is affirmative, the tower source valve 71c is closed and the tower source valve 72c is opened in Step S135. This implements the external circulation in the external path 72. Here, the external circulation in the external path 72 is exemplified as a process J5.

Then, whether the treatment liquid in the external path 72 has been replaced is determined in Step S142. The determination is made in the same manner as Step S142. When the result of the determination in Step S142 is negative, the processes return to Step S135, and the process J5 is repeatedly executed.

When the result of the determination in Step S142 is affirmative, Step S15 is executed. In the second modification, Steps S141 and S142 are performed when Step S15 is executed separately, unlike execution of Step S14. Thus, execution of Step S15 in the second modification involves opening the tower source valve 71c.

The second period in the second modification can include a fourth period during which the process J4 is executed and a fifth period during which the process J5 is executed. Specifically, this may be described as below.

The second period includes:
the fourth period during which the liquid Q is supplied from the pipe 1 (supplied to the external path 71) and the liquid Q is not supplied from the pipe 4 (not supplied to the external path 72); and
the fifth period during which the liquid Q is supplied from the pipe 4 (supplied to the external path 72) and the liquid Q is not supplied from the pipe 1 (not supplied to the external path 71).
Alternatively, the process J2 can include the processes J4 and J5.

It can be said that the controller 5 can perform control of:
causing the liquid Q to be supplied from the pipe 1 and causing the liquid Q not to be supplied from the pipe 4 during the fourth period; and
causing the liquid Q to be supplied from the pipe 4 and causing the liquid Q not to be supplied from the pipe 1 during the fifth period.

The second modification allows the appropriate external circulation according to a state outside of the circulation apparatus 100, and a state of each of the external paths 71 and 72 in the aforementioned exemplification.

A part or the entirety of the constituents in the embodiment and the modifications can be combined as necessary unless any contradiction occurs.

### EXPLANATION OF REFERENCE SIGNS

1 pipe (first pipe)
2 pipe (second pipe)
3 pipe (third pipe)
4 pipe (fourth pipe)
5 controller
11 heater
12 pump
12a inlet
12b outlet
13 valve (external circulation valve, first valve)
21 valve (internal circulation valve, second valve)
22 valve (relief valve, second valve)
71, 72 external path
100 circulation apparatus
101 inflow end (first inflow end)
201 inflow end (second inflow end)
202 outflow end (second outflow end)
302 outflow end (third outflow end)
401 inflow end (fourth inflow end)
J1 process (first process)
J2 process (second process)
J3 process (third process)
J4 process (fourth process)
J5 process (fifth process)
Q liquid
T storage tank

## Claims

1. A circulation apparatus that supplies and collects a liquid to and from an external path, the circulation apparatus comprising:
a storage tank in which the liquid is an object to be stored;
a first pipe including a first inflow end into which the liquid flows from the storage tank, the first pipe being used for supplying the liquid;
a heater in which the liquid is an object is to be heated, the heater being disposed in the first pipe;
a pump in which the liquid is an object is to be expelled, the pump being disposed in the first pipe and including an inlet connected to the first inflow end and an outlet connected to the heater;
a first valve connected in the first pipe to the outlet through the heater, the first valve being openable and closeable;
a second pipe including a second inflow end connected to the first pipe between the heater and the first valve, and a second outflow end from which the liquid flows into the storage tank, the second pipe having a pressure loss value being variable;
a third pipe including a third outflow end from which the liquid flows into the storage tank, the third pipe being used for collecting the liquid; and
a controller controlling opening and closing of the first valve, and controlling the pressure loss value,
wherein while the heater heats the liquid:
the controller closes the first valve during a first period;
the controller opens the first valve, and increases the pressure loss value during a second period after end of the first period; and
the controller opens the first valve, and reduces the pressure loss value during a third period after end of the second period.

2. The circulation apparatus according to claim 1, further comprising
a second valve that is disposed in the second pipe and can regulate a flow rate,
wherein the controller controls the second valve to control the pressure loss value.

3. The circulation apparatus according to claim 2,
wherein the second valve is an on-off valve.

4. The circulation apparatus according to claim 2,
wherein the second valve is a relief valve.

5. The circulation apparatus according to any one of claims 1 to 4,
wherein the controller ends the second period and starts the third period when a load of the pump transitions from a state larger than a predetermined value to a state smaller than the predetermined value.

6. The circulation apparatus according to any one of claims 1 to 4,
wherein the controller ends the second period and starts the third period when a temperature of the liquid flowing through the third pipe transitions from a temperature lower than a predetermined value to a temperature higher than the predetermined value.

7. The circulation apparatus according to any one of claims 1 to 6, further comprising
a fourth pipe including a fourth inflow end connected to the first valve on an opposite side of the heater, the fourth pipe being used for supplying the liquid,
wherein the second period includes a fourth period and a fifth period,
the controller causes the liquid to be supplied from the first pipe and causes the liquid not to be supplied from the fourth pipe, during the fourth period, and
the controller causes the liquid to be supplied from the fourth pipe and causes the liquid not to be supplied from the first pipe, during the fifth period.

8. The circulation apparatus according to any one of claims 1 to 7,
wherein the liquid is sulfuric acid or a dilution of sulfuric acid.

9. A method of controlling a circulation apparatus that supplies and collects a liquid to and from an external path,
the circulation apparatus including:
a storage tank in which the liquid is an object to be stored;
a first pipe including a first inflow end into which the liquid flows from the storage tank, the first pipe being used for supplying the liquid;
a heater in which the liquid is an object is to be heated, the heater being disposed in the first pipe;
a pump in which the liquid is an object is to be expelled, the pump being disposed in the first pipe and including an inlet connected to the first inflow end and an outlet connected to the heater;
a first valve connected in the first pipe to the outlet through the heater, the first valve being openable and closeable;
a second pipe including a second inflow end connected to the first pipe between the heater and the first valve, and a second outflow end from which the liquid flows into the storage tank, the second pipe having a pressure loss value being variable; and
a third pipe including a third outflow end from which the liquid flows into the storage tank, the third pipe being used for collecting the liquid,
the method, while the heater heats the liquid, comprising:
a first process of closing the first valve during a first period;
a second process of opening the first valve, and increasing the pressure loss value during a second period after end of the first period; and
a third process of opening the first valve, and reducing the pressure loss value during a third period after end of the second period.

10. The method according to claim 9,
wherein the circulation apparatus further includes a second valve that is disposed in the second pipe and can regulate a flow rate,
the method comprising controlling the pressure loss value using the second valve.

11. The method according to claim 10,
wherein the second valve is an on-off valve.

12. The method according to claim 10,
wherein the second valve is a relief valve.

13. The method according to any one of claims 9 to 12, the method comprising
ending the second period and starting the third period when a load of the pump transitions from a state larger than a predetermined value to a state smaller than the predetermined value.

14. The method according to any one of claims 9 to 12, the method comprising
ending the second period and starting the third period when a temperature of the liquid flowing through the third pipe transitions from a temperature lower than a predetermined value to a temperature higher than the predetermined value.

15. The method according to any one of claims 9 to 14,
wherein the circulation apparatus includes a fourth pipe including a fourth inflow end connected to the first valve on an opposite side of the heater, the fourth pipe being used for supplying the liquid, and
the second process includes:
a fourth process of supplying the liquid from the first pipe and not supplying the liquid from the fourth pipe; and
a fifth process of supplying the liquid from the fourth pipe and not supplying the liquid from the first pipe.

16. The method according to any one of claims 9 to 15,
wherein the liquid is sulfuric acid or a dilution of sulfuric acid.
